# EUROPEAN PATENT APPLICATION

(11) **EP 4 810 664 A1**
(43) Date of publication of application: **23.09.2026**
(21) Application number: 26162293.0
(22) Date of filing: 04.03.2026
(51) Int. Cl.: C25B 1/22, C25B 1/29, C25B 15/00, C25B 15/08

(54) **ELECTROLYTIC SULFURIC ACID SUPPLY APPARATUS AND WATER REPLACEMENT METHOD FOR ELECTROLYTIC SULFURIC ACID SUPPLY APPARATUS**

(30) Priority: 21.03.2025 JP 2025046281
(71) Applicant: SCREEN Holdings Co., Ltd., Kyoto-shi, Kyoto 602-8585 (JP)
(72) Inventor: IWAO, Michinori, Kyoto, 602-8585 (JP); KAWAGUCHI, Tatsuhiko, Kyoto, 602-8585 (JP); HORIGUCHI, Osamu, Kyoto, 602-8585 (JP); NAKAMURA, Sho, Kyoto, 602-8585 (JP)
(74) Representative: Kilian Kilian & Partner mbB

(57) **Abstract**

An electrolytic sulfuric acid supply apparatus includes a collection tank (TK1), a generation tank (TK2), a bidirectional pipe (71), a bidirectional first liquid feeder (72), an electrolytic circulator (6), a water supply (3), and a drain (4). The bidirectional pipe connects the collection tank and the generation tank. The first liquid feeder is disposed in the bidirectional pipe. The electrolytic circulator includes an electrolytic circulation pipe (61) connected to the generation tank and an electrolytic cell (65) disposed in the electrolytic circulation pipe. The water supply includes a water supply pipe (31) supplying water to the collection tank and a water supply valve (32). The drain includes a first drainage pipe (41) connected to the collection tank, a first drainage valve (42), a second drainage pipe (43) connected to the generation tank, and a second drainage valve (44).

## Description

### BACKGROUND

### Technical Field

The present disclosure relates to an electrolytic sulfuric acid supply apparatus and a water replacement method for the electrolytic sulfuric acid supply apparatus. Description of the Background Art

A cleaning system that electrolyzes sulfuric acid to generate persulfuric acid and removes a resist on a substrate using the persulfuric acid has been proposed (e.g., WO 2011/155336). In WO 2011/155336, the cleaning system includes an electrolysis unit, a first circulation line, and an electrolytic solution reservoir. The electrolysis unit is connected to the electrolytic solution reservoir through the first circulation line. A sulfuric acid solution is circulated through the first circulation line, and the electrolysis unit electrolyzes the sulfuric acid solution to generate persulfuric acid.

### SUMMARY

During maintenance of an electrolysis apparatus, sulfuric acid in a tank and a pipe is required to be drained at a high throughput.

It is thus an object of the present disclosure to provide technology enabling drainage of sulfuric acid at a high throughput.

In one aspect, an electrolytic sulfuric acid supply apparatus includes: a collection tank connected to a substrate processing apparatus via a collection pipe and storing a sulfuric acid-containing solution including an electrolytic sulfuric acid solution, the substrate processing apparatus supplying the electrolytic sulfuric acid solution to a substrate to remove organic matter on the substrate; a generation tank; a bidirectional pipe connecting the collection tank and the generation tank; a bidirectional first liquid feeder disposed in the bidirectional pipe; an electrolytic circulator including an electrolytic circulation pipe connected to the generation tank and an electrolytic cell disposed in the electrolytic circulation pipe, the electrolytic circulator causing the electrolytic cell to electrolyze the sulfuric acid-containing solution to generate the electrolytic sulfuric acid solution while circulating the sulfuric acid-containing solution through the generation tank and the electrolytic circulation pipe; a supply pipe connected to the generation tank and allowing the electrolytic sulfuric acid solution to flow therethrough toward the substrate processing apparatus; a water supply including a water supply pipe and a water supply valve disposed in the water supply pipe, the water supply pipe supplying water to the collection tank; and a drain including a first drainage pipe connected to the collection tank, a first drainage valve disposed in the first drainage pipe, a second drainage pipe connected to the generation tank, and a second drainage valve disposed in the second drainage pipe.

In one aspect, a water replacement method for an electrolytic sulfuric acid supply apparatus includes: while supplying water to a collection tank storing a sulfuric acid-containing solution including an electrolytic sulfuric acid solution drained from a substrate processing apparatus, draining the sulfuric acid-containing solution in the collection tank, the substrate processing apparatus supplying the electrolytic sulfuric acid solution to a substrate to remove organic matter on the substrate; after draining the sulfuric acid-containing solution in the collection tank, operating a bidirectional first liquid feeder disposed in a bidirectional pipe connecting the collection tank and a generation tank to drain the sulfuric acid-containing solution in the bidirectional pipe while supplying the water from the collection tank to the generation tank through the bidirectional pipe; and after draining the sulfuric acid-containing solution in the bidirectional pipe, supplying water to the generation tank and circulating the water through an electrolytic circulation pipe which is connected to the generation tank and in which an electrolytic cell is disposed to drain the sulfuric acid-containing solution in the generation tank.

These and other objects, features, aspects and advantages of the present disclosure will become more apparent from the following detailed description of the present disclosure when taken in conjunction with the accompanying drawings.

### BRIEF DESCRIPTION OF THE DRAWINGS

FIG. 1 is a plan view schematically showing one example of a configuration of a substrate processing system including electrolytic sulfuric acid supply apparatuses according to a first embodiment;
FIG. 2 is a longitudinal cross-sectional view illustrating one example of the configuration of the substrate processing system;
FIG. 3 is a block diagram schematically showing one example of an internal configuration of a controller;
FIG. 4 is a diagram schematically showing one example of a configuration of an electrolytic sulfuric acid supply apparatus;
FIG. 5 is a diagram schematically showing one example of a state of the electrolytic sulfuric acid supply apparatus during normal operation;
FIG. 6 is a diagram schematically showing one example of the state of the electrolytic sulfuric acid supply apparatus during the normal operation;
FIG. 7 is a diagram schematically showing one example of the state of the electrolytic sulfuric acid supply apparatus during the normal operation;
FIG. 8 is a flowchart showing one example of water replacement operation of the electrolytic sulfuric acid supply apparatus;
FIG. 9 is a diagram schematically showing one example of a state of the electrolytic sulfuric acid supply apparatus during the water replacement operation;
FIGs. 10A, 10B, and 10C are diagrams schematically showing examples of the state of the electrolytic sulfuric acid supply apparatus during the water replacement operation;
FIG. 11 is a diagram schematically showing one example of the state of the electrolytic sulfuric acid supply apparatus during the water replacement operation;
FIG. 12 is a diagram schematically showing one example of the state of the electrolytic sulfuric acid supply apparatus during the water replacement operation;
FIGs. 13A, 13B, and 13C are diagrams schematically showing examples of the state of the electrolytic sulfuric acid supply apparatus during the water replacement operation;
FIG. 14 is a diagram schematically showing one example of a configuration of a first liquid feeder;
FIGs. 15A and 15B are diagrams schematically showing examples of a state of the first liquid feeder during the normal operation;
FIGs. 16A and 16B are diagrams schematically showing examples of a state of the first liquid feeder during the water replacement operation;
FIG. 17 is a diagram schematically showing a first example of a configuration of an electrolytic sulfuric acid supply apparatus according to a second embodiment;
FIG. 18 is a flowchart showing one example of operation of the electrolytic sulfuric acid supply apparatus according to the second embodiment;
FIG. 19 is a diagram schematically showing one example of a state of the electrolytic sulfuric acid supply apparatus during preliminary temperature control operation;
FIG. 20 is a diagram schematically showing one example of a state of the electrolytic sulfuric acid supply apparatus during electrolytic sulfuric acid generation operation;
FIG. 21 is a flowchart showing one example of temperature control operation in the electrolytic sulfuric acid generation operation;
FIG. 22 is a diagram schematically showing a second example of the configuration of the electrolytic sulfuric acid supply apparatus according to the second embodiment; and
FIG. 23 is a diagram schematically showing a third example of the configuration of the electrolytic sulfuric acid supply apparatus according to the second embodiment.

### DESCRIPTION OF THE EMBODIMENTS

Embodiments will be described in detail below with reference to the drawings. In the drawings, dimensions and the number of components are exaggerated or simplified as necessary for ease of understanding. Components having similar configurations and functions bear the same reference signs, and description is not repeated below.

In description made below, similar components bear the same reference signs and have similar names and functions. Detailed description thereof is thus sometimes omitted to avoid redundancy.

Even when ordinal numbers, such as "first" and "second", are used in description made below, these terms are used for the sake of convenience for ease of understanding of the embodiments, and an order is not limited to an order that can be represented by the ordinal numbers.

When an expression indicating a relative or an absolute positional relationship (e.g., "in one direction", "along one direction", "parallel", "orthogonal", "central", "concentric", and "coaxial") is used, the expression not only exactly represents the positional relationship but also represents a state in which an angle or a distance is relatively changed within tolerance or to the extent that a similar function can be obtained unless otherwise noted. When an expression indicating equality (e.g., "same", "equal", and "homogeneous") is used, the expression not only represents quantitatively exact equality but also represents a state in which there is a difference within tolerance or to the extent that a similar function can be obtained unless otherwise noted. When an expression indicating a shape (e.g., a "quadrangular shape" and a "cylindrical shape") is used, the expression not only geometrically exactly represents the shape but also represents a shape having irregularities, a chamfer, and the like to the extent that a similar effect can be obtained unless otherwise noted. When an expression "comprising", "being provided with", "being equipped with", "including", or "having" one component is used, the expression is not an exclusive expression excluding the presence of the other components. When an expression "at least one of A, B, and C" is used, the expression includes only A, only B, only C, any two of A, B, and C, and all of A, B, and C.

### <First Embodiment>

### <Substrate Processing System>

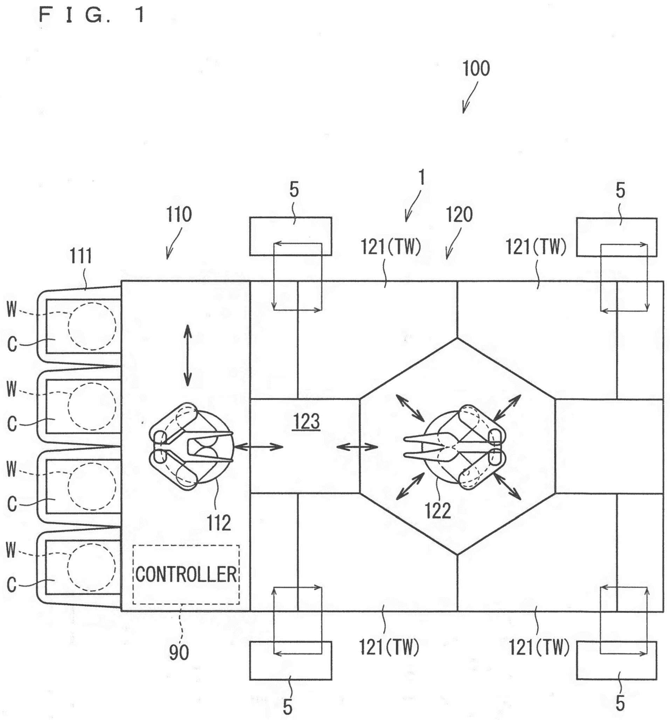

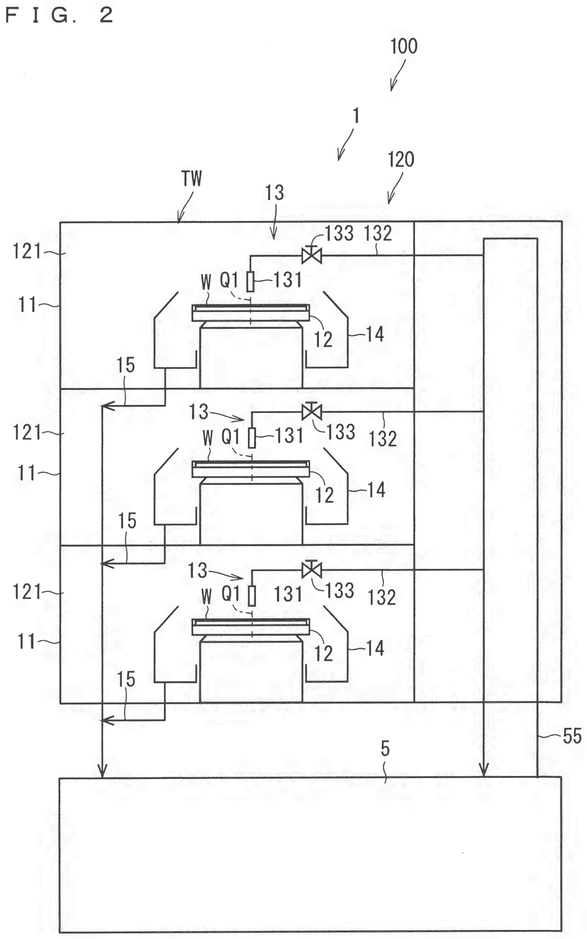

FIG. 1 is a plan view schematically showing one example of a configuration of a substrate processing system 100 including electrolytic sulfuric acid supply apparatuses 5 according to a first embodiment. FIG. 2 is a longitudinal cross-sectional view illustrating one example of the configuration of the substrate processing system 100. As illustrated in FIGs. 1 and 2, the substrate processing system 100 includes a substrate processing apparatus 1, the electrolytic sulfuric acid supply apparatuses 5, and a controller 90.

Each of the electrolytic sulfuric acid supply apparatuses 5 supplies electrolytic sulfuric acid to the substrate processing apparatus 1. Electrolytic sulfuric acid is persulfuric acid (peroxydisulfuric acid (H₂S₂O₈)) generated by electrolysis of sulfuric acid. Persulfuric acid has stronger oxidizing power than Caro's acid (H₂SO₅) at the same temperature. A liquid containing electrolytic sulfuric acid is hereinafter referred to as an electrolytic sulfuric acid solution.

While the electrolytic sulfuric acid supply apparatuses 5 are adjacent to the substrate processing apparatus 1 in plan view in the example of FIG. 1, the electrolytic sulfuric acid supply apparatuses 5 can actually be arranged in a lower layer (e.g., at a lower level) than the substrate processing apparatus 1.

The substrate processing apparatus 1 is a processing apparatus that processes a substrate W. Examples of the substrate W include a semiconductor wafer, a substrate for liquid crystal display, a substrate for organic electroluminescence (EL), a substrate for flat panel display (FPD), a substrate for optical display, a substrate for magnetic disk, a substrate for optical disc, a substrate for magnetooptical disc, a substrate for photomask, and a substrate for solar cell. The substrate W has a thin planar shape. Assume that the substrate W is a semiconductor wafer below. The substrate W has a disc shape, for example. The substrate W has a diameter of approximately 300 mm, for example, and has a thickness of approximately 0.5 mm or more and 3 mm or less, for example.

The substrate processing apparatus 1 supplies the electrolytic sulfuric acid solution supplied from each of the electrolytic sulfuric acid supply apparatuses 5 to a main surface of the substrate W. The electrolytic sulfuric acid solution thus acts on organic matter on the main surface of the substrate W to oxidatively remove the organic matter. The organic matter is a resist film, for example. The electrolytic sulfuric acid solution subjected to processing of the substrate W is collected by the electrolytic sulfuric acid supply apparatus 5.

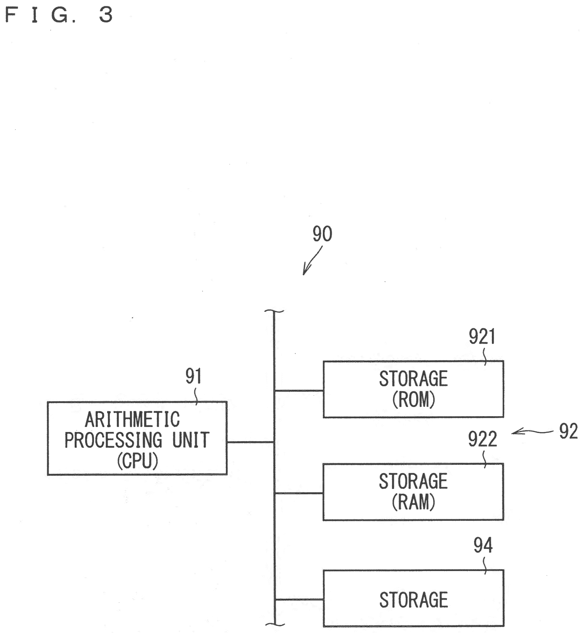

The controller 90 performs overall control of the substrate processing system 100. The controller 90 controls the substrate processing apparatus 1 and the electrolytic sulfuric acid supply apparatuses 5. FIG. 3 is a block diagram schematically showing one example of an internal configuration of the controller 90. The controller 90 is an electronic circuit and includes an arithmetic processing unit 91 and a storage 92, for example. In the specific example of FIG. 3, the arithmetic processing unit 91 and the storage 92 are connected to each other via a bus 93. The arithmetic processing unit 91 may be a central processor unit (CPU), for example. The storage 92 may include a non-transitory storage (e.g., read only memory (ROM)) 921 and a transitory storage (e.g., random access memory (RAM)) 922. A program that defines processing performed by the controller 90 may be stored in the non-transitory storage 921, for example. The arithmetic processing unit 91 executes the program, so that the controller 90 can perform processing defined by the program. In the example of FIG. 3, the controller 90 is also connected to a storage 94. The storage 94 includes at least one of a magnetic disk, an optical disc, flash memory, and a memory card, for example. Part or all of processing performed by the controller 90 may be performed by a hardware circuit, such as a dedicated logic circuit.

As described above, the controller 90 includes at least one processor. The processor includes at least one circuit or unit configured to execute instructions stored in memory to perform computation or processing, for example. The processor includes at least any of a central processor unit (CPU), an application-specific integrated circuit (ASCI), a field-programmable gate array (FPGA), a digital signal processor (DSP), a digital flow processor (DFP), a micro controller unit (an MCU), a graphics processing unit (GPU), and a neural processing unit (an NPU), for example. The controller 90 may be implemented by cooperation of a plurality of computers or processors, and, in this case, the plurality of computers or processors may be arranged at positions away from one another.

The substrate processing apparatus 1 will be outlined first, and the electrolytic sulfuric acid supply apparatuses 5 according to the present embodiment will be described next below.

In the example of FIG. 1, the substrate processing apparatus 1 includes an indexer block 110 and a processing block 120. The processing block 120 is a part that mainly performs processing of the substrate W, and the indexer block 110 is a part that mainly transports the substrate W between an outside of the substrate processing apparatus 1 and the processing block 120.

The indexer block 110 includes load ports 111 and a first transport 112. Externally transported substrate containers (hereinafter referred to as carriers) C are mounted to the load ports 111. Each of the carriers C contains therein a plurality of substrates W arranged to be spaced apart from one another in a vertical direction, for example. In the example of FIG. 1, the plurality of load ports 111 are arranged.

The first transport 112 is a transport robot and can take an unprocessed substrate W out of the carrier C mounted to each of the load ports 111. The first transport 112 can also be referred to as an indexer robot. The first transport 112 transports the unprocessed substrate W taken out of the carrier C to the processing block 120. The processing block 120 can perform processing on the unprocessed substrate W. The first transport 112 can also receive a processed substrate W from the processing block 120 and transport the processed substrate W to the carrier C mounted to each of the load ports 111.

In the example of FIG. 1, the processing block 120 includes a plurality of processing units 121 and a second transport 122. The second transport 122 is a transport robot and can transport the substrate W between the first transport 112 and each of the plurality of processing units 121. In the example of FIG. 1, the processing block 120 further includes a mount 123. The mount 123 is a shelf to which a plurality of substrates W can be mounted while being arranged in the vertical direction, for example. The first transport 112 mounts the unprocessed substrate W to the mount 123. The second transport 122 takes the unprocessed substrate W out of the mount 123 and transports the substrate W to one of the processing units 121. The processing unit 121 performs processing on the substrate W. A configuration of the processing unit 121 will be outlined below. The second transport 122 takes the processed substrate W out of the processing unit 121 and transports the substrate W to the mount 123. The first transport 112 takes the substrate W out of the mount 123 and transports the substrate W to the carrier C mounted to each of the load ports 111.

In the example of FIG. 1, the plurality of (e.g., four) processing units 121 are arranged to surround the second transport 122 in plan view. The second transport 122 can also be referred to as a center robot. At each position in plan view, a plurality of processing units 121 may be stacked in the vertical direction. That is to say, a plurality of (four in the figure) towers TW each including the plurality of processing units 121 stacked in the vertical direction may be arranged to surround the second transport 122.

Each of the processing units 121 supplies various processing solutions to the substrate W and performs various types of processing on the substrate W. One of the processing solutions includes electrolytic sulfuric acid. The electrolytic sulfuric acid solution is supplied to the substrate W, so that organic matter on the substrate W is oxidatively removed.

### <Processing Units 121>

In the example of FIG. 2, each of the towers TW includes three processing units 121. The number of processing units 121 constituting the tower TW can be changed as appropriate. The processing units 121 may have the same internal configuration. In the example of FIG. 2, each of the processing units 121 includes a chamber 11, a substrate holder 12, a discharger 13, and a cup 14. The chamber 11 has a box shape. An internal space of the chamber 11 corresponds to a processing space for processing of the substrate W. A side wall of the chamber 11 has an unillustrated transport port and a shutter. The second transport 122 transports the substrate W into and out of the processing unit 121 through the transport port with the shutter being opened.

The substrate holder 12 is disposed in the chamber 11 and holds the substrate W in a horizontal orientation. The horizontal orientation is herein an orientation in which a thickness direction of the substrate W extends along the vertical direction. The substrate holder 12 may rotate the substrate W around a rotational axis Q1. The rotational axis Q1 is an axis passing through the center of the substrate W and extending along the vertical direction. The substrate holder 12 is also referred to as a spin chuck. The substrate holder 12 may be a clamping spin chuck or may be an adsorption spin chuck. The substrate holder 12 is controlled by the controller 90.

The discharger 13 discharges the electrolytic sulfuric acid solution to the main surface (e.g., an upper surface) of the substrate W held by the substrate holder 12. In the example of FIG. 2, the discharger 13 includes a nozzle 131, a liquid supply pipe 132, and a supply valve 133. In the example of FIG. 2, the nozzle 131 is disposed above the substrate W held by the substrate holder 12 within the chamber 11. A downstream end of the liquid supply pipe 132 is connected to the nozzle 131. The electrolytic sulfuric acid solution from a corresponding one of the electrolytic sulfuric acid supply apparatuses 5 is supplied to the liquid supply pipe 132. The supply valve 133 is disposed in the liquid supply pipe 132. The supply valve 133 is controlled by the controller 90 and switches between opening and closing of the liquid supply pipe 132.

The controller 90 opens the supply valve 133 during rotation of the substrate W. The electrolytic sulfuric acid solution is thus discharged from a discharge port of the nozzle 131 toward the main surface of the substrate W being rotated. The electrolytic sulfuric acid solution lands on the main surface of the substrate W. The electrolytic sulfuric acid solution is subjected to centrifugal force associated with rotation of the substrate W to flow on the main surface of the substrate W radially outwards and splashes outwards from a peripheral edge of the substrate W. The electrolytic sulfuric acid solution acts on the main surface of the substrate W to oxidatively remove organic matter present on the main surface of the substrate W. When the controller 90 closes the supply valve 133, discharge of the electrolytic sulfuric acid solution from the nozzle 131 ends.

The cup 14 has a tubular shape and is disposed to surround the substrate holder 12 within the chamber 11. The cup 14 catches the electrolytic sulfuric acid solution splashing from the peripheral edge of the substrate W. The electrolytic sulfuric acid solution flows downwards along an inner peripheral surface of the cup 14.

The discharger 13 may be disposed to be able to supply various processing solutions. For example, the discharger 13 may be disposed to be able to supply a rinse liquid, such as pure water, to the substrate W. The discharger 13 supplies the rinse liquid to the main surface of the substrate W, so that the rinse liquid can wash away the electrolytic sulfuric acid solution on the main surface of the substrate W.

### <Electrolytic Sulfuric Acid Supply Apparatuses 5>

Each of the electrolytic sulfuric acid supply apparatuses 5 supplies the electrolytic sulfuric acid solution to the substrate processing apparatus 1 and collects the electrolytic sulfuric acid solution drained from the substrate processing apparatus 1. In the substrate processing apparatus 1, electrolytic sulfuric acid reacts with organic matter on the substrate W to oxidatively remove the organic matter, so that the electrolytic sulfuric acid solution drained from the substrate processing apparatus 1 has a lower electrolytic sulfuric acid concentration than the electrolytic sulfuric acid solution supplied to the substrate processing apparatus 1. Electrolytic sulfuric acid can autolyze to Caro's acid and hydroxyl radicals (OH radicals), so that the electrolytic sulfuric acid concentration of electrolytic sulfuric acid drained from the substrate processing apparatus 1 can be reduced over time.

A sulfuric acid-containing solution is herein introduced as a superordinate concept of the electrolytic sulfuric acid solution. The sulfuric acid-containing solution is a liquid containing sulfuric acid and water and is a concept including the electrolytic sulfuric acid solution.

The electrolytic sulfuric acid supply apparatus 5 electrolyzes the sulfuric acid-containing solution collected from the substrate processing apparatus 1 and increases the electrolytic sulfuric acid concentration to a concentration equal to or higher than a predetermined reference concentration. The sulfuric acid-containing solution having an electrolytic sulfuric acid concentration equal to or higher than the reference concentration corresponds to the electrolytic sulfuric acid solution. That is to say, the electrolytic sulfuric acid supply apparatus 5 electrolyzes the sulfuric acid-containing solution to generate the electrolytic sulfuric acid solution again. The electrolytic sulfuric acid supply apparatus 5 then supplies the electrolytic sulfuric acid solution to the substrate processing apparatus 1 again. The sulfuric acid-containing solution drained from the substrate processing apparatus 1 is thus reused, so that wastage of sulfuric acid can be reduced. That is to say, the electrolytic sulfuric acid supply apparatus 5 contributes to saving of the liquid.

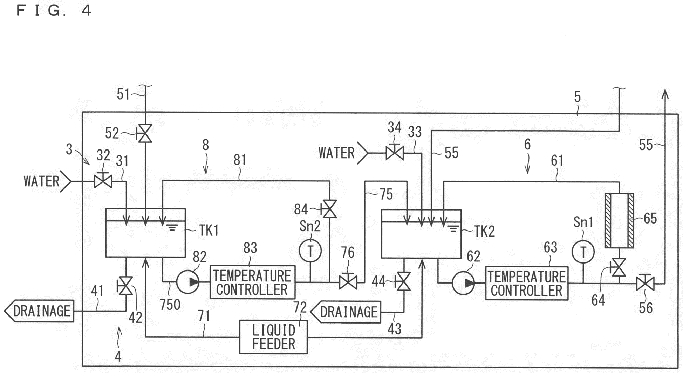

FIG. 4 is a diagram schematically showing one example of a configuration of each of the electrolytic sulfuric acid supply apparatuses 5. As illustrated in FIG. 4, the electrolytic sulfuric acid supply apparatus 5 includes a collection tank Tk1, a generation tank Tk2, a bidirectional pipe 71, a bidirectional first liquid feeder 72, an electrolytic circulator 6, and a drain 4.

A configuration of the electrolytic sulfuric acid supply apparatus 5 relating to normal operation will be described first, and then a configuration of the electrolytic sulfuric acid supply apparatus 5 relating to water replacement operation during maintenance will be described next below. As will be described below, the normal operation includes collection of the sulfuric acid-containing solution from the substrate processing apparatus 1, generation of the electrolytic sulfuric acid solution, and supply of the electrolytic sulfuric acid solution to the substrate processing apparatus 1, and the water replacement operation includes drainage of the sulfuric acid-containing solution from each tank and each pipe of the electrolytic sulfuric acid supply apparatus 5.

### <Configuration Relating to Normal Operation>

The collection tank Tk1 stores the sulfuric acid-containing solution drained from the substrate processing apparatus 1. In the example of FIG. 4, the collection tank Tk1 is connected to the cup 14 of each of the processing units 121 of the substrate processing apparatus 1 via a collection pipe 51. The electrolytic sulfuric acid solution subjected to processing of the substrate W in each of the processing units 121 flows into the collection pipe 51 through the cup 14 and flows into the collection tank Tk1 through the collection pipe 51.

In the example of FIG. 4, the electrolytic sulfuric acid supply apparatus 5 also includes a temperature control circulator 8. The temperature control circulator 8 controls a temperature of the sulfuric acid-containing solution in the collection tank Tk1. The temperature control circulator 8 includes a temperature control circulation pipe 81 and a temperature controller 83. The temperature control circulation pipe 81 is connected to the collection tank Tk1. As one example, an upstream end of the temperature control circulation pipe 81 is connected to a bottom of the collection tank Tk1, and a downstream end of the temperature control circulation pipe 81 is connected to a ceiling of the collection tank Tk1.

The temperature control circulator 8 circulates the sulfuric acid-containing solution through a first temperature control circulation path including the collection tank Tk1 and the temperature control circulation pipe 81. In the example of FIG. 4, the temperature control circulator 8 also includes a second liquid feeder 82 and a temperature control circulation valve 84. The second liquid feeder 82 is disposed in the temperature control circulation pipe 81. The second liquid feeder 82 is controlled by the controller 90 and feeds the sulfuric acid-containing solution from the upstream end to the downstream end of the temperature control circulation pipe 81. The second liquid feeder 82 is a pump, such as a magnetic levitation centrifugal pump. The second liquid feeder 82 may be a pump that unidirectionally feeds the sulfuric acid-containing solution, for example. The temperature control circulation valve 84 is disposed in the temperature control circulation pipe 81. Opening and closing of the temperature control circulation valve 84 are controlled by the controller 90. In the example of FIG. 4, the temperature control circulation valve 84 is disposed to be closer to the downstream end of the temperature control circulation pipe 81 than the second liquid feeder 82 is.

The temperature controller 83 is controlled by the controller 90 and controls the temperature of the sulfuric acid-containing solution flowing through the temperature control circulation pipe 81. In the example of FIG. 4, the temperature controller 83 is disposed between the second liquid feeder 82 and the temperature control circulation valve 84. In the example of FIG. 4, the temperature control circulator 8 also includes a temperature sensor Sn2. The temperature sensor Sn2 measures the temperature of the sulfuric acid-containing solution flowing through the temperature control circulation pipe 81 and outputs an electrical signal indicating a result of measurement to the controller 90. In the example of FIG. 4, the temperature sensor Sn2 is disposed between the temperature controller 83 and the temperature control circulation valve 84. The controller 90 may control the temperature controller 83 based on the temperature measured by the temperature sensor Sn2. The controller 90 can thus control the temperature of the sulfuric acid-containing solution with higher accuracy.

The sulfuric acid-containing solution flowing into the collection tank Tk1 through the collection pipe 51 is sometimes at a high temperature. For example, the electrolytic sulfuric acid solution heated by a heater to a high temperature is sometimes supplied to the substrate W in each of the processing units 121. This is because electrolytic sulfuric acid at a high temperature has a high reactivity. In this case, the sulfuric acid-containing solution at a high temperature flows into the collection tank Tk1 through the collection pipe 51.

The temperature controller 83 may thus cool the sulfuric acid-containing solution. That is to say, the temperature controller 83 may include a cooler. The temperature controller 83 may include an unillustrated heat exchanger, an unillustrated refrigerant pipe, and an unillustrated refrigerant cooling source, for example. The heat exchanger includes an unillustrated sulfuric acid path and an unillustrated refrigerant path, and the sulfuric acid path is inserted into the temperature control circulation pipe 81. As one example, the sulfuric acid path is inserted into the temperature control circulation pipe 81 at a position between the second liquid feeder 82 and the temperature control circulation valve 84. The refrigerant path is inserted into the refrigerant pipe and forms a portion of the refrigerant pipe. Opposite ends of the refrigerant pipe are connected to the refrigerant cooling source. A refrigerant cooled by the refrigerant cooling source flows into the refrigerant path through the refrigerant pipe and extracts heat from the sulfuric acid-containing solution in the sulfuric acid path at the heat exchanger. Thus, the sulfuric acid-containing solution is cooled, and the refrigerant is heated. The refrigerant flows into the refrigerant cooling source through the refrigerant pipe again and is cooled by the refrigerant cooling source. The refrigerant cooling source may be a heat pump, for example.

When the controller 90 opens the temperature control circulation valve 84 and operates the second liquid feeder 82 and the temperature controller 83, the sulfuric acid-containing solution is subjected to temperature control by the temperature controller 83 while being circulated through the first temperature control circulation path including the collection tank Tk1 and the temperature control circulation pipe 81. A temperature of the sulfuric acid-containing solution thus falls within a predetermined range.

In the example of FIG. 4, the collection tank Tk1 is connected to the generation tank Tk2 via a sulfuric acid supply pipe 75. In the example of FIG. 4, a pipe portion of the sulfuric acid supply pipe 75 closer to the collection tank Tk1 doubles as the temperature control circulation pipe 81. The pipe portion is hereinafter also referred to as a common pipe 750. In the example of FIG. 4, the second liquid feeder 82 and the temperature controller 83 are arranged in the common pipe 750. A downstream end of the sulfuric acid supply pipe 75 is connected to a ceiling of the generation tank Tk2. A sulfuric acid supply valve 76 is disposed in a pipe portion of the sulfuric acid supply pipe 75 other than the common pipe 750. Opening and closing of the sulfuric acid supply valve 76 are controlled by the controller 90.

When the controller 90 opens the sulfuric acid supply valve 76 and operates the second liquid feeder 82, the sulfuric acid-containing solution is supplied from the collection tank Tk1 to the generation tank Tk2 through the sulfuric acid supply pipe 75. The generation tank Tk2 stores the sulfuric acid-containing solution.

The electrolytic circulator 6 generates the electrolytic sulfuric acid solution from the sulfuric acid-containing solution in the generation tank Tk2. As illustrated in FIG. 4, the electrolytic circulator 6 includes an electrolytic circulation pipe 61 and an electrolytic cell 65. The electrolytic circulation pipe 61 is connected to the generation tank Tk2. As one example, an upstream end of the electrolytic circulation pipe 61 is connected to a bottom of the generation tank Tk2, and a downstream end of the electrolytic circulation pipe 61 is connected to the ceiling of the generation tank Tk2. The electrolytic circulator 6 circulates the sulfuric acid-containing solution through an electrolytic circulation path including the generation tank Tk2 and the electrolytic circulation pipe 61.

In the example of FIG. 4, the electrolytic circulator 6 includes a third liquid feeder 62 and an electrolytic circulation valve 64. The third liquid feeder 62 is disposed in the electrolytic circulation pipe 61. The third liquid feeder 62 is controlled by the controller 90 and feeds the sulfuric acid-containing solution from the upstream end to the downstream end of the electrolytic circulation pipe 61. The third liquid feeder 62 is a pump, such as a magnetic levitation centrifugal pump. The third liquid feeder 62 may be a pump that unidirectionally feeds the sulfuric acid-containing solution, for example. The electrolytic circulation valve 64 is disposed in the electrolytic circulation pipe 61. Opening and closing of the electrolytic circulation valve 64 are controlled by the controller 90. In the example of FIG. 4, the electrolytic circulation valve 64 is disposed to be closer to the downstream end of the electrolytic circulation pipe 61 than the third liquid feeder 62 is.

The electrolytic cell 65 is disposed in the electrolytic circulation pipe 61. In the example of FIG. 4, the electrolytic cell 65 is disposed to be closer to the downstream end of the electrolytic circulation pipe 61 than the third liquid feeder 62 is and is, more specifically, disposed to be closer to the downstream end of the electrolytic circulation pipe 61 than the electrolytic circulation valve 64 is. The sulfuric acid-containing solution flows into the electrolytic cell 65. The electrolytic cell 65 has an internal flow path, and the sulfuric acid-containing solution passes through the internal flow path of the electrolytic cell 65. The electrolytic cell 65 can be disposed with the internal flow path extending along the vertical direction. In this case, the sulfuric acid-containing solution passes through the electrolytic cell 65 along the vertical direction. The electrolytic cell 65 includes a cathode (unillustrated) and an anode (unillustrated) to apply a voltage to the sulfuric acid-containing solution in the internal flow path. The cathode and the anode are diamond electrodes, for example. The cathode and the anode are connected to a DC power supply (unillustrated). The cathode and the anode are exposed to the internal flow path of the electrolytic cell 65 and can be in contact with the sulfuric acid-containing solution, for example.

When the controller 90 operates the third liquid feeder 62 while opening the electrolytic circulation valve 64, the sulfuric acid-containing solution in the generation tank Tk2 is circulated through the electrolytic circulation path. The sulfuric acid-containing solution thus continues to pass through the electrolytic cell 65. When the controller 90 operates the electrolytic cell 65, in other words, when the DC power supply outputs a DC voltage, the DC voltage is applied to the sulfuric acid-containing solution in the internal flow path of the electrolytic cell 65. Sulfuric acid is thus electrolyzed in the internal flow path of the electrolytic cell 65 to generate electrolytic sulfuric acid. Since the sulfuric acid-containing solution continues to pass through the electrolytic cell 65, the electrolytic sulfuric acid concentration of the sulfuric acid-containing solution increases over time to be equal to or higher than the predetermined reference concentration. That is to say, the electrolytic sulfuric acid solution is generated from the sulfuric acid-containing solution. It can be said that the electrolytic circulator 6 is an electrolytic sulfuric acid generator that generates the electrolytic sulfuric acid solution.

Heat is generated in the electrolytic cell 65 in association with electrolysis. The temperature of the sulfuric acid-containing solution being circulated thus increases. When the temperature is extremely high, electrolytic sulfuric acid is likely to autolyze while having a high reactivity. On the other hand, when the temperature is extremely low, sulfuric acid has a high viscosity to make it difficult to circulate the sulfuric acid-containing solution. Thus, in the example of FIG. 4, the electrolytic circulator 6 includes a temperature controller 63. The temperature controller 63 is controlled by the controller 90 and controls the temperature of the sulfuric acid-containing solution flowing through the electrolytic circulation pipe 61. The temperature controller 63 may include a heater. The heater may be an electric resistance heater including a heating wire or may be an optical heater that emits light (e.g., infrared rays) for heating, for example. The heater heats the sulfuric acid-containing solution flowing through the electrolytic circulation pipe 61 to increase the temperature of the sulfuric acid-containing solution. The viscosity of the sulfuric acid-containing solution can thus be reduced. The temperature controller 63 may include a cooler. The cooler of the temperature controller 63 may be similar to the cooler of the temperature controller 83. The cooler of the temperature controller 63 cools the sulfuric acid-containing solution flowing through the electrolytic circulation pipe 61 to reduce the temperature of the sulfuric acid-containing solution. The temperature of the sulfuric acid-containing solution can thus be reduced to a temperature at which electrolytic sulfuric acid is less likely to autolyze.

With reference to FIGs. 2 and 4, an external circulation pipe 55 is connected to the generation tank Tk2. An upstream end of the external circulation pipe 55 is connected to the electrolytic circulation pipe 61 at a position between the third liquid feeder 62 and the electrolytic circulation valve 64. In the example of FIG. 4, the upstream end of the external circulation pipe 55 is connected to the electrolytic circulation pipe 61 at a position between the temperature controller 63 and the electrolytic circulation valve 64. A downstream end of the external circulation pipe 55 is connected to the ceiling of the generation tank Tk2. In the example of FIG. 2, a portion of the external circulation pipe 55 extends adjacent to the tower TW along the vertical direction, and an upstream end of the liquid supply pipe 132 of each of the processing units 121 is connected to the external circulation pipe 55.

With reference to FIG. 4, an external circulation valve 56 is disposed in the external circulation pipe 55. Opening and closing of the external circulation valve 56 are controlled by the controller 90.

When the controller 90 opens the external circulation valve 56 and operates the third liquid feeder 62, the electrolytic sulfuric acid solution is circulated through an external circulation path including the generation tank Tk2 and the external circulation pipe 55. When the supply valve 133 of each of the processing units 121 is opened, the electrolytic sulfuric acid solution is supplied from the external circulation pipe 55 to the substrate W through the liquid supply pipe 132 and the nozzle 131. The electrolytic sulfuric acid solution reacts with the organic matter on the substrate W to decompose the organic matter and remove the organic matter from the substrate W.

The electrolytic sulfuric acid solution subjected to processing of the substrate W is collected by the collection tank Tk1 through the cup 14 and the collection pipe 51. Since the electrolytic sulfuric acid solution removes the organic matter on the substrate W, the electrolytic sulfuric acid solution drained from the substrate processing apparatus 1 can contain residual organic matter. That is to say, the electrolytic sulfuric acid solution can contain the residual organic matter having not been decomposed. The sulfuric acid-containing solution in the collection tank Tk1 can thus contain the residual organic matter. When the sulfuric acid-containing solution containing such residual organic matter is supplied from the collection tank Tk1 to the generation tank Tk2, and the electrolytic circulator 6 circulates the sulfuric acid-containing solution, the residual organic matter flows into the electrolytic cell 65. Due to the residual organic matter, a failure of the electrolytic cell 65 might occur. For example, the residual organic matter might react with the cathode and the anode of the electrolytic cell 65 to damage functions of the cathode and the anode.

Thus, in the first embodiment, the bidirectional pipe 71 and the bidirectional first liquid feeder 72 are arranged (see FIG. 4). The bidirectional pipe 71 connects the collection tank Tk1 and the generation tank Tk2. In the example of FIG. 4, one end of the bidirectional pipe 71 is connected to the bottom of the collection tank Tk1, and the other end of the bidirectional pipe 71 is connected to the bottom of the generation tank Tk2. The first liquid feeder 72 is disposed in the bidirectional pipe 71. The first liquid feeder 72 is controlled by the controller 90 and can feed the electrolytic sulfuric acid solution from the generation tank Tk2 to the collection tank Tk1. The electrolytic sulfuric acid solution having high oxidizing power is thus supplied to the collection tank Tk1 to decompose the residual organic matter in the collection tank Tk1.

The first liquid feeder 72 can feed a liquid from the collection tank Tk1 to the generation tank Tk2 under control performed by the controller 90. Technical significance thereof will be described in detail below.

### <Normal Operation>

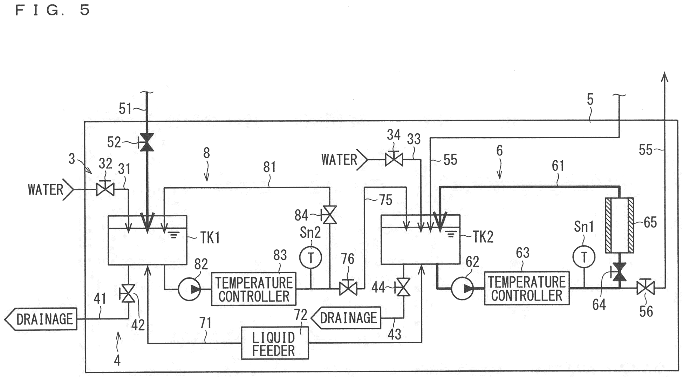

One specific example of the normal operation of the electrolytic sulfuric acid supply apparatus 5 will be described next. FIGs. 5 to 7 are diagrams schematically showing examples of a state of the electrolytic sulfuric acid supply apparatus 5 during the normal operation. In FIGs. 5 to 7, a pipe through which a liquid flows is schematically shown in a thick line, and an opened valve is schematically shown by a filled valve.

In the normal operation, the electrolytic sulfuric acid supply apparatus 5 performs electrolytic sulfuric acid generation operation of generating the electrolytic sulfuric acid solution. Specifically, the controller 90 opens the electrolytic circulation valve 64 and operates the third liquid feeder 62, the temperature controller 63, and the electrolytic cell 65. The sulfuric acid-containing solution is thus circulated through the electrolytic circulation path as illustrated in FIG. 5. The temperature controller 63 controls the temperature of the sulfuric acid-containing solution being circulated. For example, the controller 90 controls the temperature controller 63 so that the temperature of the sulfuric acid-containing solution is within a predetermined temperature range. The predetermined temperature range is set in advance, for example. The temperature range is a temperature range in which the sulfuric acid-containing solution has a viscosity suitable for circulation and electrolytic sulfuric acid is less likely to autolyze, for example.

The electrolytic sulfuric acid supply apparatus 5 may include a temperature sensor Sn1. The temperature sensor Sn1 measures the temperature of the sulfuric acid-containing solution circulated through the electrolytic circulation path and outputs an electrical signal indicating a result of measurement to the controller 90. The temperature sensor Sn1 may be disposed between the temperature controller 63 and the electrolytic cell 65. The controller 90 may control the temperature controller 63 so that the temperature measured by the temperature sensor Sn1 falls within a predetermined temperature range.

The electrolytic cell 65 electrolyzes the sulfuric acid-containing solution to generate electrolytic sulfuric acid. The sulfuric acid-containing solution is circulated through the electrolytic circulation path, so that the sulfuric acid-containing solution continues to flow into the electrolytic cell 65. The electrolytic cell 65 thus continues to electrolyze the sulfuric acid-containing solution. The electrolytic sulfuric acid concentration of the sulfuric acid-containing solution through the electrolytic circulation path is thus increased over time. The electrolytic sulfuric acid solution is thus to be stored in the generation tank Tk2.

In the electrolytic sulfuric acid generation operation, the controller 90 may open the external circulation valve 56. Thus, the sulfuric acid-containing solution is initially circulated through the external circulation path, and, upon generation of the electrolytic sulfuric acid solution, the electrolytic sulfuric acid solution is circulated through the external circulation path.

In the normal operation, when the electrolytic sulfuric acid supply apparatus 5 generates the electrolytic sulfuric acid solution, the substrate processing apparatus 1 supplies the electrolytic sulfuric acid solution to the substrate W as appropriate. That is to say, the electrolytic sulfuric acid solution is supplied from the external circulation pipe 55 to each of the processing units 121 through the liquid supply pipe 132. A storage amount of the electrolytic sulfuric acid solution in the generation tank Tk2 is thus gradually reduced.

In the example of FIG. 5, in the normal operation, a collection valve 52 is opened, and the electrolytic sulfuric acid solution from the substrate processing apparatus 1 flows into the collection tank Tk1 through the collection pipe 51. That is to say, the controller 90 opens the collection valve 52, so that, when each of the processing units 121 of the substrate processing apparatus 1 drains the electrolytic sulfuric acid solution, the sulfuric acid-containing solution is collected by the collection tank Tk1 through the collection pipe 51. The controller 90 may control the temperature control circulator 8 as necessary to control the temperature of the sulfuric acid-containing solution in the collection tank Tk1.

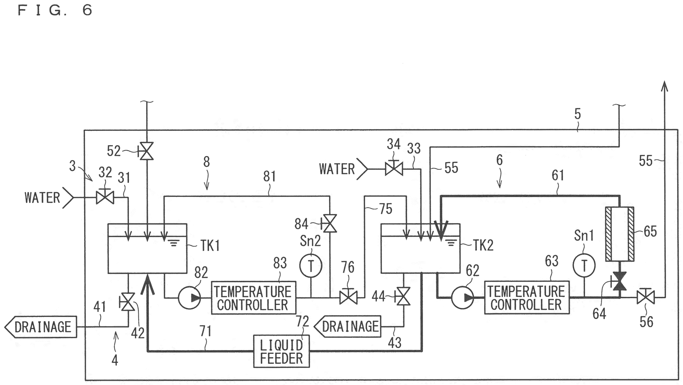

The sulfuric acid-containing solution in the collection tank Tk1 can contain the residual organic matter. Thus, as illustrated in FIG. 6, the controller 90 controls the first liquid feeder 72 after generation of electrolytic sulfuric acid to supply the electrolytic sulfuric acid solution from the generation tank Tk2 to the collection tank Tk1 through the bidirectional pipe 71. A trigger to supply the electrolytic sulfuric acid solution from the generation tank Tk2 to the collection tank Tk1 can be set as appropriate. For example, the electrolytic sulfuric acid supply apparatus 5 may supply the electrolytic sulfuric acid solution to the collection tank Tk1 when a storage amount in the collection tank Tk1 is equal to or greater than a predetermined collection storage amount or when the storage amount in the generation tank Tk2 is equal to or smaller than a predetermined electrolytic storage amount. When the electrolytic sulfuric acid solution having high oxidizing power is supplied to the collection tank Tk1, the electrolytic sulfuric acid solution decomposes the residual organic matter in the collection tank Tk1. The amount of the residual organic matter in the collection tank Tk1 can thus be reduced.

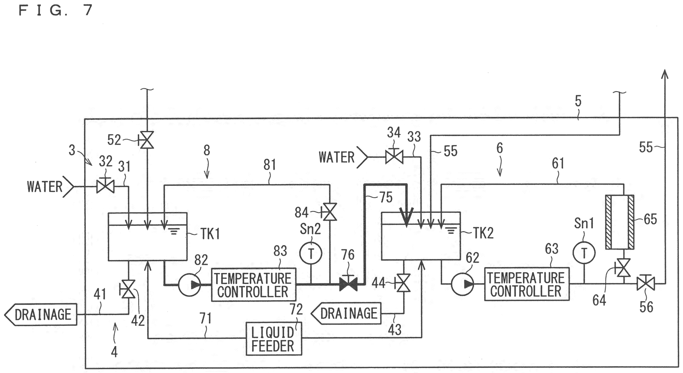

Next, the controller 90 opens the sulfuric acid supply valve 76 and operates the second liquid feeder 82. Thus, as illustrated in FIG. 7, the sulfuric acid-containing solution in which the amount of the residual organic matter has been reduced is supplied from the collection tank Tk1 to the generation tank Tk2 through the sulfuric acid supply pipe 75. The electrolytic circulator 6 causes the electrolytic cell 65 to electrolyze the sulfuric acid-containing solution while circulating the sulfuric acid-containing solution through the electrolytic circulation path to generate the electrolytic sulfuric acid solution again.

As described above, the electrolytic sulfuric acid supply apparatus 5 supplies the electrolytic sulfuric acid solution in the generation tank Tk2 to the collection tank Tk1 to reduce the amount of the residual organic matter in the collection tank Tk1. The electrolytic sulfuric acid supply apparatus 5 then supplies the sulfuric acid-containing solution from the collection tank Tk1 to the generation tank Tk2. The sulfuric acid-containing solution containing a small amount of the residual organic matter thus passes through the electrolytic cell 65 when the electrolytic circulator 6 performs the electrolytic sulfuric acid generation operation. A likelihood of a failure of the electrolytic cell 65 due to the residual organic matter can thus be reduced.

In the above-mentioned specific example, in the normal operation, the sulfuric acid-containing solution is supplied from the collection tank Tk1 to the generation tank Tk2 through the sulfuric acid supply pipe 75, and the electrolytic sulfuric acid solution is supplied from the generation tank Tk2 to the collection tank Tk1 through the bidirectional pipe 71. Thus, in the normal operation, the bidirectional pipe 71 is generally used as a unidirectional pipe. Retention of impurities in the bidirectional pipe 71 due to a bidirectional flow of a liquid through the bidirectional pipe 71 can thus be reduced. That is to say, while impurities can reciprocate in the bidirectional pipe 71 and retain in the bidirectional pipe 71 when a liquid bidirectionally flows through the bidirectional pipe 71, a likelihood of such retention can be reduced.

### <Configuration Relating to Water Replacement Operation>

A configuration relating to the water replacement operation of draining the sulfuric acid-containing solution in each tank and each pipe to an outside during maintenance will be described next.

As illustrated in FIG. 4, the electrolytic sulfuric acid supply apparatus 5 includes the drain 4 that drains the sulfuric acid-containing solution. For example, the drain 4 includes a first drainage pipe 41, a first drainage valve 42, a second drainage pipe 43, and a second drainage valve 44. In the example of FIG. 4, an upstream end of the first drainage pipe 41 is connected to the bottom of the collection tank Tk1, and a downstream end of the first drainage pipe 41 is connected to external drainage facilities (e.g., plant utility facilities). The first drainage valve 42 is disposed in the first drainage pipe 41. Opening and closing of the first drainage valve 42 are controlled by the controller 90. The controller 90 opens the first drainage valve 42 to drain the sulfuric acid-containing solution in the collection tank Tk1 to the outside through the first drainage pipe 41.

An upstream end of the second drainage pipe 43 is connected, for example, to the bottom of the generation tank Tk2, and a downstream end of the second drainage pipe 43 is connected to the external drainage facilities. The second drainage valve 44 is disposed in the second drainage pipe 43. Opening and closing of the second drainage valve 44 are controlled by the controller 90. The controller 90 opens the second drainage valve 44 to drain the sulfuric acid-containing solution in the generation tank Tk2 to the outside through the second drainage pipe 43.

The drain 4 may include another drainage pipe in place of at least any one of the first drainage pipe 41 and the second drainage pipe 43. Alternatively, the drain 4 may include another drainage pipe in addition to the first drainage pipe 41 and the second drainage pipe 43. An upstream end of the other drainage pipe may be connected to a midway portion of any of the pipes in the electrolytic sulfuric acid supply apparatus 5. Another drainage valve is disposed in the other drainage pipe. The sulfuric acid-containing solution from the pipe may be drained to the outside through the other drainage pipe.

As illustrated in FIG. 4, the electrolytic sulfuric acid supply apparatus 5 may include a water supply 3. For example, the water supply 3 includes a water supply pipe 31 and a water supply valve 32. In the example of FIG. 4, a downstream end of the water supply pipe 31 is connected to the ceiling of the collection tank Tk1, and an upstream end of the water supply pipe 31 is connected to a water supply source. The water supply source includes a tank for storing water (e.g., pure water). The water supply valve 32 is disposed in the water supply pipe 31. Opening and closing of the water supply valve 32 are controlled by the controller 90. The controller 90 opens the water supply valve 32 to supply water to the collection tank Tk1. As will be described below, water is supplied to the collection tank Tk1, and the sulfuric acid-containing solution and water are drained from the collection tank Tk1, so that the sulfuric acid-containing solution in the collection tank Tk1 can be rinsed with water.

As illustrated in FIG. 4, the water supply 3 may include a water supply pipe 33 and a water supply valve 34. A downstream end of the water supply pipe 33 is connected, for example, to the ceiling of the generation tank Tk2, and an upstream end of the water supply pipe 33 is connected to a water supply source. The water supply valve 34 is disposed in the water supply pipe 33. Opening and closing of the water supply valve 34 are controlled by the controller 90. The controller 90 opens the water supply valve 34 to supply water to the generation tank Tk2. As will be described below, water is supplied to the generation tank Tk2, and the sulfuric acid-containing solution and water are drained from the generation tank Tk2, so that the sulfuric acid-containing solution in the generation tank Tk2 can be rinsed with water.

The water supply 3 may include another supply pipe in place of at least any one of the water supply pipe 31 and the water supply pipe 33 or may include another supply pipe in addition to the water supply pipe 31 and the water supply pipe 33. A downstream end of the other supply pipe may be connected to a midway portion of any of the above-mentioned pipes, and another supply valve may be disposed in the other supply pipe. Water may be supplied to the collection tank Tk1 or the generation tank Tk2 through the other supply pipe.

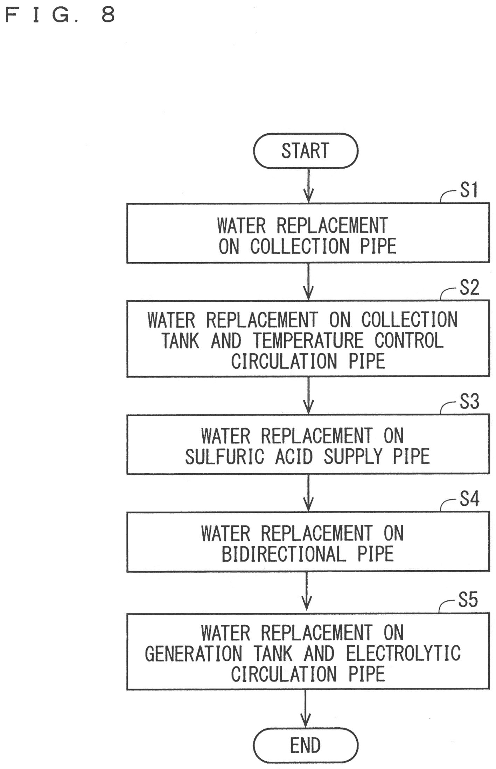

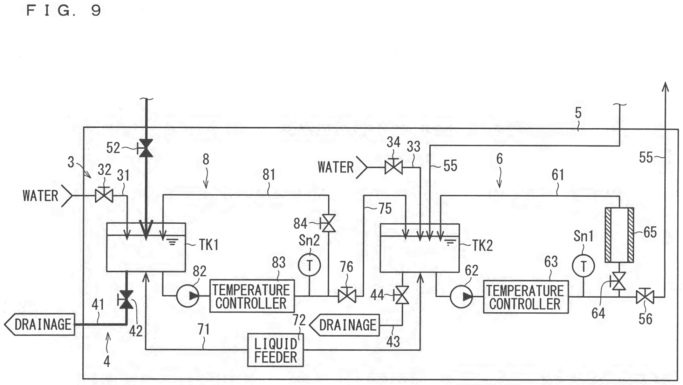

FIG. 8 is a flowchart showing one example of the water replacement operation of the electrolytic sulfuric acid supply apparatus 5. FIGs. 9 to 13 are diagrams schematically showing examples of a state of the electrolytic sulfuric acid supply apparatus 5 during the water replacement operation. The electrolytic sulfuric acid supply apparatus 5 performs water replacement on each tank and each pipe in an order described below.

First, the electrolytic sulfuric acid supply apparatus 5 performs water replacement on the collection pipe 51 (step S1). As one example, the controller 90 first opens the collection valve 52 and the first drainage valve 42. Each of the processing units 121 drains pure water to the collection pipe 51. Thus, as illustrated in FIG. 9, the sulfuric acid-containing solution in the collection pipe 51 is washed away by water and drained to the outside through the collection tank Tk1 and the first drainage pipe 41. The sulfuric acid-containing solution in the collection pipe 51 can thus be drained to the outside. Sulfuric acid can thus be drained although water remains in the collection pipe 51. In other words, sulfuric acid in the collection pipe 51 can be replaced with water.

Since water from the substrate processing apparatus 1 is supplied to the collection tank Tk1 trough the collection pipe 51, it can be said that a configuration including the substrate processing apparatus 1, the collection pipe 51, and the collection valve 52 is the water supply 3.

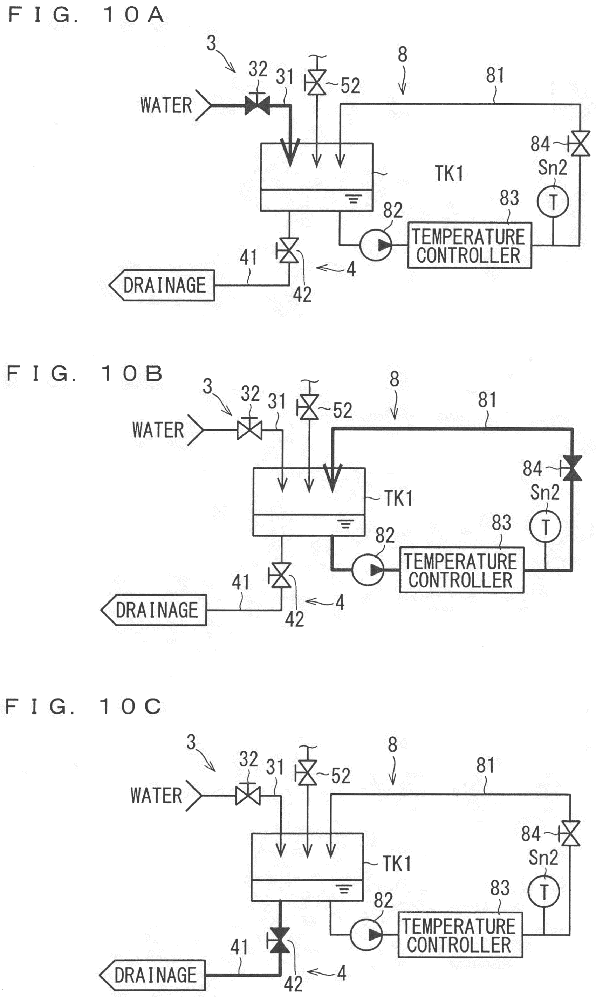

Next, the electrolytic sulfuric acid supply apparatus 5 performs water replacement on the collection tank Tk1 and the temperature control circulation pipe 81 (step S2). As one example, the controller 90 may first open the water supply valve 32 to supply water to the collection tank Tk1 (see also FIG. 10A). The substrate processing apparatus 1 may supply water to the collection tank Tk1. Next, the controller 90 may circulate water and the sulfuric acid-containing solution through the temperature control circulator 8 (see also FIG. 10B). In this case, the controller 90 may not operate the temperature controller 83. Water is supplied to the collection tank Tk1, and water and the sulfuric acid-containing solution are circulated through the first temperature control circulation path, so that a sulfuric acid concentration in the first temperature control circulation path is reduced. Next, the controller 90 may open the first drainage valve 42 to drain the sulfuric acid-containing solution in the collection tank Tk1 (see also FIG. 10C).

The electrolytic sulfuric acid supply apparatus 5 may perform at least any two of supply of water to the collection tank Tk1 illustrated in FIG. 10A, circulation through the first temperature control circulation path illustrated in FIG. 10B, and drainage from the collection tank Tk1 illustrated in FIG. 10C in parallel. The electrolytic sulfuric acid supply apparatus 5 may also repeatedly perform operation including supply of water to the collection tank Tk1, circulation through the first temperature control circulation path, and drainage from the collection tank Tk1 a predetermined number of times. Sulfuric acid in the collection tank Tk1 and the temperature control circulation pipe 81 can thus more surely be drained. In other words, sulfuric acid in the collection tank Tk1 and the temperature control circulation pipe 81 can more surely be replaced with water.

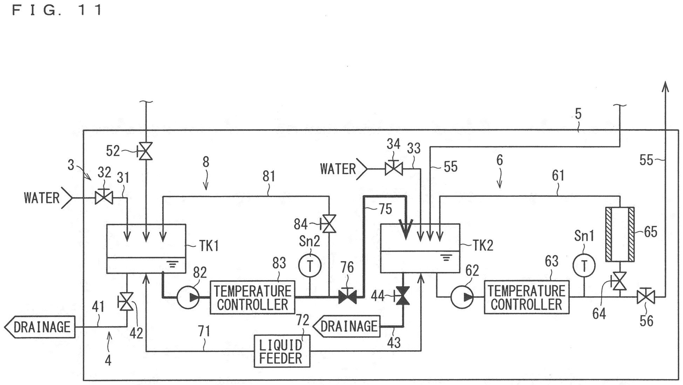

Next, the electrolytic sulfuric acid supply apparatus 5 performs water replacement on the sulfuric acid supply pipe 75 (step S3). As one example, the controller 90 first opens the water supply valve 32 to supply water to the collection tank Tk1. The substrate processing apparatus 1 may supply water to the collection tank Tk1. The controller 90 opens the sulfuric acid supply valve 76 and operates the third liquid feeder 62. Water thus washes away the sulfuric acid-containing solution in the sulfuric acid supply pipe 75 toward the generation tank Tk2 as illustrated in FIG. 11. The sulfuric acid-containing solution and water are thus supplied to the generation tank Tk2. That is to say, sulfuric acid in the sulfuric acid supply pipe 75 is drained to the generation tank Tk2. The controller 90 may open the second drainage valve 44. In this case, the sulfuric acid-containing solution and water are drained to the outside through the generation tank Tk2 and the second drainage pipe 43.

The electrolytic sulfuric acid supply apparatus 5 may perform at least two of supply of water to the collection tank Tk1, supply of the sulfuric acid-containing solution and water to the generation tank Tk2 through the sulfuric acid supply pipe 75, and drainage from the generation tank Tk2 in parallel. The electrolytic sulfuric acid supply apparatus 5 may also repeatedly perform operation including supply of water to the collection tank Tk1, supply of the sulfuric acid-containing solution and water to the generation tank Tk2 through the sulfuric acid supply pipe 75, and drainage from the generation tank Tk2 a predetermined number of times. Sulfuric acid in the sulfuric acid supply pipe 75 can thus more surely be drained. In other words, sulfuric acid in the sulfuric acid supply pipe 75 can more surely be replaced with water.

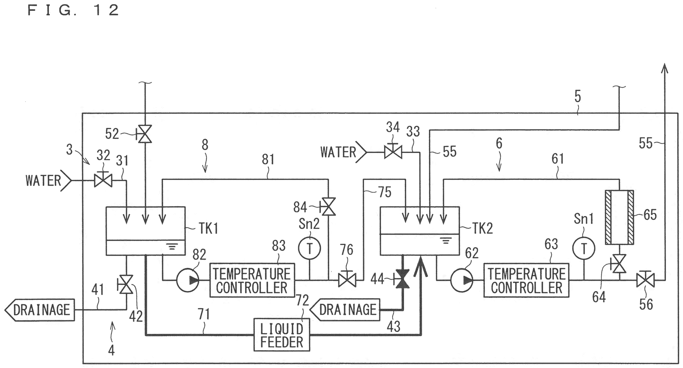

Next, the electrolytic sulfuric acid supply apparatus 5 performs water replacement on the bidirectional pipe 71 (step S4). As one example, the controller 90 first opens the water supply valve 32 to supply water to the collection tank Tk1. The substrate processing apparatus 1 may supply water to the collection tank Tk1. The controller 90 operates the bidirectional first liquid feeder 72 to feed water from the collection tank Tk1 to the generation tank Tk2 through the bidirectional pipe 71. Water thus washes away the sulfuric acid-containing solution in the bidirectional pipe 71 toward the generation tank Tk2. That is to say, sulfuric acid in the bidirectional pipe 71 is drained to the generation tank Tk2. The controller 90 may open the second drainage valve 44. In this case, as illustrated in FIG. 12, the sulfuric acid-containing solution and water are drained to the outside through the bidirectional pipe 71, the generation tank Tk2, and the second drainage pipe 43.

The electrolytic sulfuric acid supply apparatus 5 may perform at least two of supply of water to the collection tank Tk1, supply of the sulfuric acid-containing solution and water to the generation tank Tk2 through the bidirectional pipe 71, and drainage from the generation tank Tk2 in parallel. The electrolytic sulfuric acid supply apparatus 5 may also repeatedly perform operation including supply of water to the collection tank Tk1, supply of the sulfuric acid-containing solution and water to the generation tank Tk2 through the bidirectional pipe 71, and drainage from the generation tank Tk2 a predetermined number of times. Sulfuric acid in the bidirectional pipe 71 can thus more surely be drained. In other words, sulfuric acid in the bidirectional pipe 71 can more surely be replaced with water.

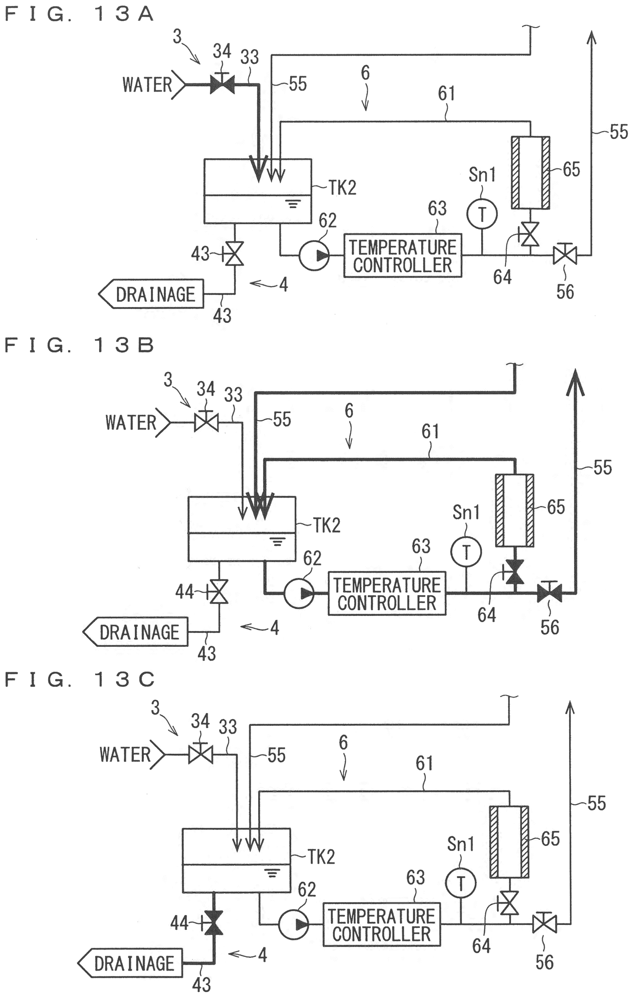

Next, the electrolytic sulfuric acid supply apparatus 5 performs water replacement on the generation tank Tk2 and the electrolytic circulation pipe 61 (step S5). As one example, the controller 90 first opens the water supply valve 34 to supply water to the generation tank Tk2 (see FIG. 13A). Water may alternatively be supplied from the collection tank Tk1 to the generation tank Tk2. Next, the controller 90 may cause the electrolytic circulator 6 to circulate the sulfuric acid-containing solution and water through the electrolytic circulation path (see FIG. 13B). In this case, the controller 90 may not operate the electrolytic cell 65 and the temperature controller 63. The electrolytic sulfuric acid supply apparatus 5 herein includes the external circulation pipe 55. The controller 90 may thus open the external circulation valve 56. The sulfuric acid-containing solution and water are thus circulated through the external circulation path (see FIG. 13B). Since water is supplied to the generation tank Tk2, and the sulfuric acid-containing solution and water are circulated through the electrolytic circulation path and the external circulation path, a sulfuric acid concentration of the sulfuric acid-containing solution in the electrolytic circulation path and the external circulation path is reduced. Next, the controller 90 may open the second drainage valve 44, for example, to drain a liquid in the generation tank Tk2 (see FIG. 13C).

The electrolytic sulfuric acid supply apparatus 5 may perform at least any two of supply of water to the generation tank Tk2, circulation through the electrolytic circulation path (and further the external circulation pipe 55), and drainage from the generation tank Tk2 in parallel. The electrolytic sulfuric acid supply apparatus 5 may also repeatedly perform operation including supply of water to the generation tank Tk2, circulation through the electrolytic circulation path (and further the external circulation path), and drainage from the generation tank Tk2 a predetermined number of times. Sulfuric acid in the generation tank Tk2 and the electrolytic circulation path (and further the external circulation path) can thus more surely be drained. In other words, sulfuric acid in the generation tank Tk2 and the electrolytic circulation path (and further the external circulation path) can more surely be replaced with water.

As described above, in the water replacement operation according to the first embodiment, sulfuric acid in the collection pipe 51 is drained first, sulfuric acid in the collection tank Tk1 and the temperature control circulation pipe 81 is drained next, sulfuric acid in the sulfuric acid supply pipe 75 and the bidirectional pipe 71 is drained next, and sulfuric acid in the generation tank Tk2 and the electrolytic circulation path (and further the external circulation path) is drained next. That is to say, sulfuric acid is drained to the outside sequentially from a pipe and a tank on an upstream side.

For comparison, a case where the first liquid feeder 72 is a unidirectional liquid feeder from the generation tank Tk2 to the collection tank Tk1 will be described. In this case, after drainage of sulfuric acid in the collection pipe 51 (step S1), the collection tank Tk1 and the temperature control circulation pipe 81 (step S2), the sulfuric acid supply pipe 75 (step S3), and the generation tank Tk2 (step S5), water is supplied to the generation tank Tk2, and the sulfuric acid-containing solution and water are supplied from the generation tank Tk2 to the collection tank Tk1 through the bidirectional pipe 71. The sulfuric acid-containing solution having a high sulfuric acid concentration thus flows into the collection tank Tk1 again after drainage of sulfuric acid in the collection tank Tk1 (step S1). It is thus necessary to supply water to the collection tank Tk1 again and drain sulfuric acid in the collection tank Tk1 again. This leads to reduction in throughput in the water replacement operation.

In contrast, in the above-mentioned example, sulfuric acid is drained sequentially from an upstream part. Specifically, after drainage of sulfuric acid in the collection tank Tk1 (step S1) and before drainage of sulfuric acid in the generation tank Tk2 and the electrolytic circulation path (step S5), the sulfuric acid-containing solution and water are supplied from the collection tank Tk1 to the generation tank Tk2 through each of the sulfuric acid supply pipe 75 and the bidirectional pipe 71 (step S3 and step S4). A flow of the sulfuric acid-containing solution having a high sulfuric acid concentration into the collection tank Tk1 again after drainage of sulfuric acid in the collection tank Tk1 (step S1) can thus be avoided. The electrolytic sulfuric acid supply apparatus 5 can thus perform the water replacement operation at a higher throughput.

In the above-mentioned example, sulfuric acid in the sulfuric acid supply pipe 75 is drained (step S3) after drainage of sulfuric acid in the collection tank Tk1 and the temperature control circulation pipe 81 (step S2) and before drainage of sulfuric acid in the bidirectional pipe 71 (step S4). That is to say, promptly after drainage of sulfuric acid in the temperature control circulation pipe 81, sulfuric acid in the sulfuric acid supply pipe 75 connected to the temperature control circulation pipe 81 is drained. If step S4 follows step S2, the sulfuric acid-containing solution in the sulfuric acid supply pipe 75 might flow into the temperature control circulation pipe 81. In this case, if sulfuric acid flows into a portion of the temperature control circulation pipe 81 other than a supply path with the sulfuric acid supply pipe 75, sulfuric acid might remain in the temperature control circulation pipe 81 even when step S3 is performed. In contrast, in the above-mentioned example, sulfuric acid in the sulfuric acid supply pipe 75 is drained promptly after drainage of sulfuric acid in the temperature control circulation pipe 81, so that such remaining of sulfuric acid can more surely be avoided.

While the electrolytic sulfuric acid supply apparatus 5 includes the sulfuric acid supply pipe 75 in the above-mentioned specific example, the sulfuric acid supply pipe 75 is not necessarily required to be disposed in a broader concept. In the normal operation, electrolytic sulfuric acid may be supplied from the generation tank Tk2 to the collection tank Tk1 through the bidirectional pipe 71, and the sulfuric acid-containing solution may be supplied from the collection tank Tk1 to the generation tank Tk2 through the bidirectional pipe 71. In this case, in the water replacement operation, step S1, step S2, step S4, and step S5 are performed in this order.

### <Bidirectional Liquid Feeder>

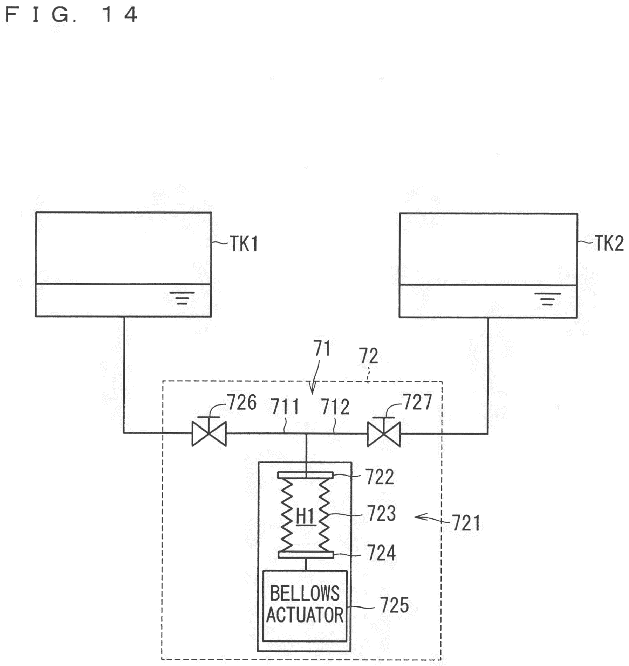

FIG. 14 is a diagram schematically showing one example of a configuration of the first liquid feeder 72. In the example of FIG. 14, the first liquid feeder 72 includes a bellows pump 721 not including a check valve, a collection-side valve 726, and a generation-side valve 727. The bellows pump 721 includes an upper part 722, bellows 723, a lower part 724, and a bellows actuator 725. The bellows 723 have a corrugated cylindrical shape and are stretchable along a central axis thereof. The upper part 722 is attached to one end along the central axis of the bellows 723, and the lower part 724 is attached to the other end of the bellows 723. The upper part 722, the bellows 723, and the lower part 724 form an internal space H1. The internal space H1 is connected to a pipe that diverges from a midway portion of the bidirectional pipe 71.

A portion of the bidirectional pipe 71 closer to the collection tank Tk1 than the midway portion is and a portion of the bidirectional pipe 71 closer to the generation tank Tk2 than the midway portion is are hereinafter respectively referred to as a collection-side pipe 711 and a generation-side pipe 712.

The bellows actuator 725 is controlled by the controller 90 and moves the lower part 724 relative to the upper part 722 in a direction along the central axis of the bellows 723. Specifically, the bellows actuator 725 moves the lower part 724 between a first position close to the upper part 722 and a second position away from the upper part 722. The bellows actuator 725 includes an air cylinder, for example. When the bellows actuator 725 moves the lower part 724 from the first position to the second position, the volume of the internal space H1 increases, and a liquid in the bidirectional pipe 71 is sucked into the internal space H1. On the other hand, when the bellows actuator 725 moves the lower part 724 from the second position to the first position, the volume of the internal space H1 is reduced, and a liquid in the internal space H1 is discharged to the bidirectional pipe 71.

The collection-side valve 726 is disposed in the bidirectional pipe 71 at a position closer to the collection tank Tk1 than the bellows pump 721 is. That is to say, the collection-side valve 726 is disposed in the collection-side pipe 711. The generation-side valve 727 is disposed in the bidirectional pipe 71 at a position closer to the generation tank Tk2 than the bellows pump 721 is. That is to say, the generation-side valve 727 is disposed in the generation-side pipe 712. Opening and closing of each of the collection-side valve 726 and the generation-side valve 727 are controlled by the controller 90.

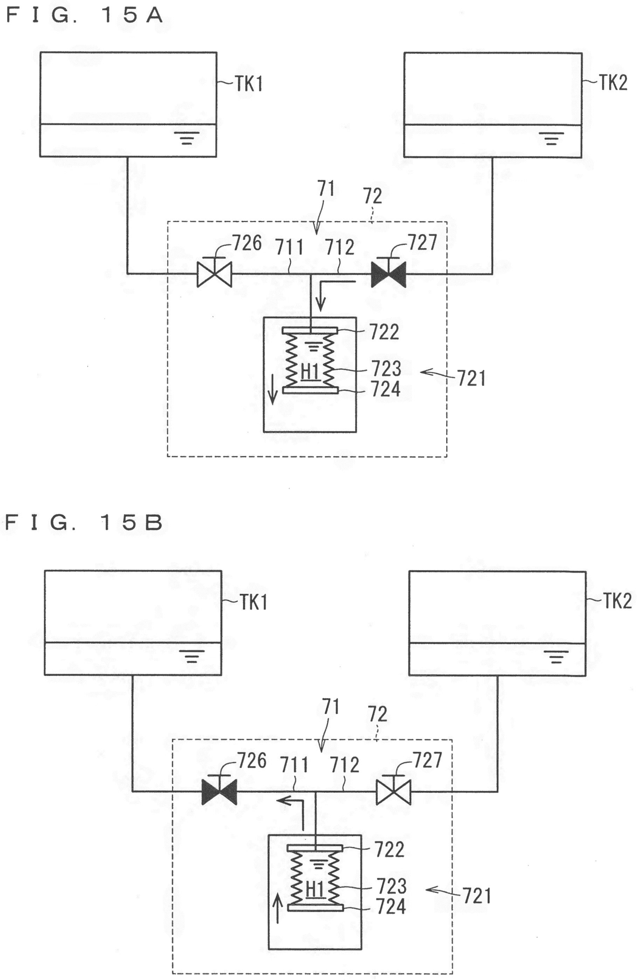

FIGs. 15A and 15B are diagrams schematically showing examples of a state of the first liquid feeder 72 during the normal operation. That is to say, FIGs. 15A and 15B illustrate states of operation when the electrolytic sulfuric acid solution is supplied from the generation tank Tk2 to the collection tank Tk1. The controller 90 causes the bellows actuator 725 to move the lower part 724 from the first position to the second position with the collection-side valve 726 being closed and the generation-side valve 727 being opened (see FIG. 15A). The electrolytic sulfuric acid solution in the generation tank Tk2 thus moves toward the internal space H1 through the generation-side pipe 712 and flows into the internal space H1.

Next, the controller 90 causes the bellows actuator 725 to move the lower part 724 from the second position to the first position with the collection-side valve 726 being opened and the generation-side valve 727 being closed (see FIG. 15B). The electrolytic sulfuric acid solution in the internal space H1 is thus supplied to the collection tank Tk1 through the collection-side pipe 711.

The controller 90 alternately performs the above-mentioned types of operation, so that the electrolytic sulfuric acid solution in the generation tank Tk2 can be supplied to the collection tank Tk1 in a constant amount at a time.

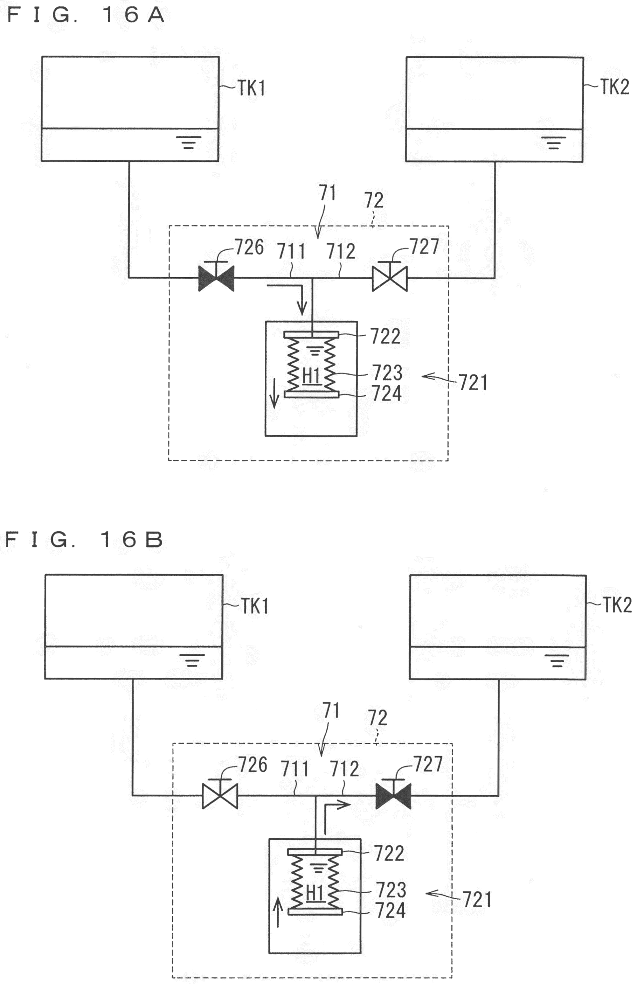

FIGs. 16A and 16B are diagrams schematically showing examples of a state of the first liquid feeder 72 during the water replacement operation. That is to say, FIGs. 16A and 16B illustrate states of operation when water is supplied from the collection tank Tk1 to the generation tank Tk2. The controller 90 causes the bellows actuator 725 to move the lower part 724 from the first position to the second position with the collection-side valve 726 being opened and the generation-side valve 727 being closed (see FIG. 16A). Water in the collection tank Tk1 thus moves toward the internal space H1 through the collection-side pipe 711 and flows into the internal space H1.

Next, the controller 90 causes the bellows actuator 725 to move the lower part 724 from the second position to the first position with the collection-side valve 726 being closed and the generation-side valve 727 being opened (see FIG. 16B). Water in the internal space H1 is thus supplied to the generation tank Tk2 through the generation-side pipe 712.

The controller 90 alternately performs the above-mentioned types of operation, so that water in the collection tank Tk1 can be supplied to the generation tank Tk2 in a constant amount at a time.

As described above, the first liquid feeder 72 in FIG. 14 can bidirectionally feed a liquid. Furthermore, the first liquid feeder 72 includes the bellows pump 721. The bellows pump 721 does not include a slide mechanism that is in contact with the liquid in the internal space H1. Generation of particles due to a slide can thus be reduced to reduce a likelihood of entry of the particles into the electrolytic sulfuric acid solution.

When such a bidirectional first liquid feeder 72 is used, the electrolytic sulfuric acid supply apparatus 5 including the sulfuric acid supply pipe 75 is particularly useful. This is because a liquid feeding rate of the first liquid feeder 72 in FIG. 14 is not so high. That is to say, the first liquid feeder 72 in FIG. 14 cannot supply a liquid to a supply destination during suction into the internal space H1, so that the liquid feeding rate is reduced accordingly. The sulfuric acid supply pipe 75 for supplying the sulfuric acid-containing solution from the collection tank Tk1 to the generation tank Tk2 during the normal operation is thus disposed separately from the bidirectional pipe 71. In this case, in the normal operation, the controller 90 opens the sulfuric acid supply valve 76 and operates the unidirectional third liquid feeder 62, so that the sulfuric acid-containing solution can be supplied from the collection tank Tk1 to the generation tank Tk2 through the sulfuric acid supply pipe 75 at a higher liquid feeding rate.

### <Second Embodiment>

In a second embodiment, an attempt to control the temperature of the sulfuric acid-containing solution in the generation tank Tk2 during the normal operation with higher accuracy will be made.

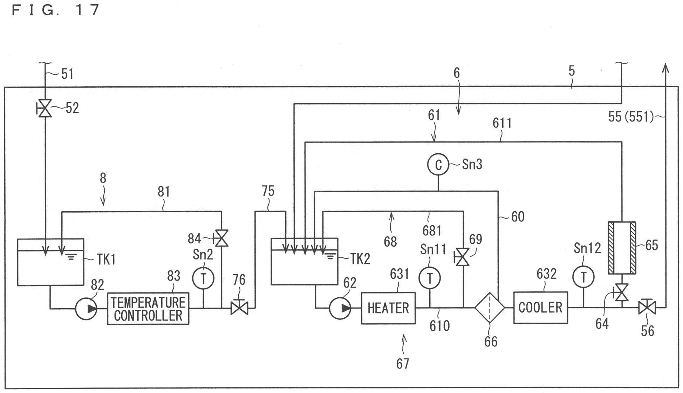

FIG. 17 is a diagram schematically showing a first example of a configuration of an electrolytic sulfuric acid supply apparatus 5 according to the second embodiment. In the example of FIG. 17, the water supply 3, the drain 4, the bidirectional pipe 71, and the first liquid feeder 72 are not illustrated. The electrolytic sulfuric acid supply apparatus 5 according to the second embodiment, however, may include the water supply 3, the drain 4, the bidirectional pipe 71, and the first liquid feeder 72.

The example of the configuration of the electrolytic sulfuric acid supply apparatus 5 according to the second embodiment differs from that of the electrolytic sulfuric acid supply apparatus 5 according to the first embodiment in a configuration of the electrolytic circulator 6. In the second embodiment, the electrolytic circulator 6 further includes a preliminary temperature control circulator 67 and a filter 66. In the second embodiment, a heater 631 and a cooler 632 are arranged as the temperature controller 63.

The filter 66 is disposed in the electrolytic circulation pipe 61. The filter 66 captures impurities in the sulfuric acid-containing solution. The impurities include particles, for example. In the example of FIG. 17, the filter 66 is disposed between the third liquid feeder 62 and the electrolytic circulation valve 64. The filter 66 has a mesh shape, for example. The sulfuric acid-containing solution is thus less likely to pass through the filter 66 when having a high viscosity. The viscosity of sulfuric acid decreases with increasing temperature.

The preliminary temperature control circulator 67 thus increases the temperature of the sulfuric acid-containing solution in the generation tank Tk2 to a temperature equal to or higher than a predetermined reference temperature to reduce the viscosity of the sulfuric acid-containing solution. The reference temperature is a temperature equal to or higher than a temperature at which the sulfuric acid-containing solution can pass through the filter 66 at a sufficient flow rate and is set in advance, for example.

In the example of FIG. 17, the preliminary temperature control circulator 67 includes a temperature control circulation pipe 68, a temperature control circulation valve 69, the heater 631, and a first temperature sensor Sn11. The temperature control circulation pipe 68 is connected to the generation tank Tk2. In the example of FIG. 17, a pipe portion of the temperature control circulation pipe 68 closer to the generation tank Tk2 doubles as the electrolytic circulation pipe 61. The pipe portion is hereinafter also referred to as a common circulation pipe 610. An upstream end of the common circulation pipe 610 is connected to the generation tank Tk2. A pipe portion of the temperature control circulation pipe 68 other than the common circulation pipe 610 is also referred to as a temperature control separate pipe 681. The temperature control separate pipe 681 connects a downstream end of the common circulation pipe 610 and the generation tank Tk2. In the example of FIG. 17, the third liquid feeder 62 and the heater 631 are arranged in the common circulation pipe 610. In the example of FIG. 17, the third liquid feeder 62 is disposed to be closer to the upstream end of the common circulation pipe 610 than the heater 631 is. The temperature control circulation valve 69 is disposed in the temperature control separate pipe 681. Opening and closing of the temperature control circulation valve 69 are controlled by the controller 90.

As will be described next, the controller 90 performs preliminary temperature control operation before the electrolytic sulfuric acid generation operation. The preliminary temperature control operation is operation of heating the sulfuric acid-containing solution in the generation tank Tk2 to a temperature equal to or higher than a reference temperature. Specifically, the controller 90 opens the temperature control circulation valve 69 and operates the third liquid feeder 62 and the heater 631. The sulfuric acid-containing solution is thus circulated through a second temperature control circulation path including the generation tank Tk2 and the temperature control circulation pipe 68 and is heated by the heater 631. The temperature of the sulfuric acid-containing solution being circulated thus increases over time. The viscosity of the sulfuric acid-containing solution is thus reduced over time.

The first temperature sensor Sn11 is disposed immediately after the heater 631. In the example of FIG. 17, the first temperature sensor Sn11 is disposed between the heater 631 and the temperature control circulation valve 69. In other words, the first temperature sensor Sn11 is disposed to be closer to the downstream end of the common circulation pipe 610 than the heater 631 is. The first temperature sensor Sn11 is thus disposed between the heater 631 and the filter 66. The first temperature sensor Sn11 measures the temperature of the sulfuric acid-containing solution flowing through the common circulation pipe 610 and outputs a result of measurement to the controller 90.

The cooler 632 is disposed in the electrolytic circulation pipe 61 and cools the sulfuric acid-containing solution flowing through the electrolytic circulation pipe 61. In the example of FIG. 17, the cooler 632 is disposed in an electrolytic separate pipe 611 of the electrolytic circulation pipe 61 other than the common circulation pipe 610. In the example of FIG. 17, the filter 66, the cooler 632, the electrolytic circulation valve 64, and the electrolytic cell 65 are arranged in the electrolytic separate pipe 611. In the example of FIG. 17, the cooler 632 is disposed to be closer to an upstream end of the electrolytic separate pipe 611 than the electrolytic cell 65 is. As a specific example, the cooler 632 is disposed between the filter 66 and the electrolytic circulation valve 64.

The electrolytic circulator 6 also includes a second temperature sensor Sn12. The second temperature sensor Sn12 is disposed in the electrolytic circulation pipe 61 at a position between the cooler 632 and the electrolytic cell 65. In the example of FIG. 17, the second temperature sensor Sn12 is disposed between the cooler 632 and the electrolytic circulation valve 64. The second temperature sensor Sn12 measures the temperature of the sulfuric acid-containing solution flowing through the electrolytic separate pipe 611 and outputs a result of measurement to the controller 90. The controller 90 controls the cooler 632 based on the temperature measured by the second temperature sensor Sn12.

In the example of FIG. 17, the electrolytic circulator 6 also includes a concentration separate pipe 60 for measuring the electrolytic sulfuric acid concentration of the sulfuric acid-containing solution. An upstream end of the concentration separate pipe 60 is connected to the electrolytic circulation path at a position between the filter 66 and the electrolytic cell 65. In the example of FIG. 17, the upstream end of the concentration separate pipe 60 is connected to a secondary-side portion of the filter 66. A downstream end of the concentration separate pipe 60 is connected, for example, to the ceiling of the generation tank Tk2.

A concentration sensor Sn3 is disposed in the concentration separate pipe 60. The concentration sensor Sn3 measures the electrolytic sulfuric acid concentration of the sulfuric acid-containing solution flowing through the concentration separate pipe 60 and outputs an electrical signal indicating a result of measurement to the controller 90. The controller 90 may permit supply of the electrolytic sulfuric acid solution to the substrate processing apparatus 1 or the collection tank Tk1 when the electrolytic sulfuric acid concentration is equal to or higher than a predetermined reference concentration.

### <Operation>

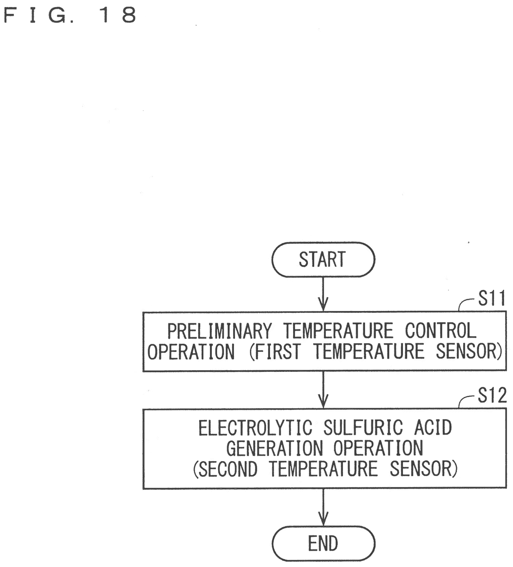

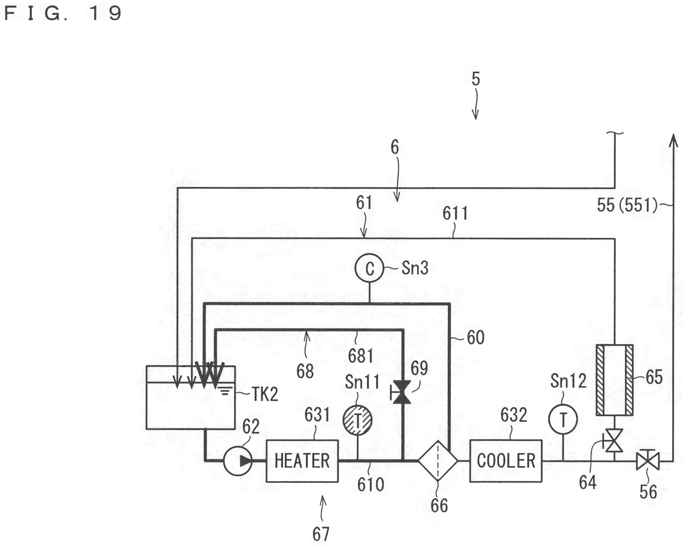

Next, an overview of operation of the electrolytic sulfuric acid supply apparatus 5 will be described. FIG. 18 is a flowchart showing one example of operation of the electrolytic sulfuric acid supply apparatus 5 according to the second embodiment. First, the electrolytic sulfuric acid supply apparatus 5 performs the preliminary temperature control operation (step S11). FIG. 19 is a diagram schematically showing one example of a state of the electrolytic sulfuric acid supply apparatus 5 during the preliminary temperature control operation. The controller 90 opens the temperature control circulation valve 69 and operates the third liquid feeder 62 and the heater 631. The sulfuric acid-containing solution is thus heated by the heater 631 while being circulated through the second temperature control circulation path. Thus, the temperature of the sulfuric acid-containing solution being circulated increases over time, and the viscosity of the sulfuric acid-containing solution is reduced over time.

The controller 90 may open the electrolytic circulation valve 64 or may open the external circulation valve 56 during the preliminary temperature control operation. A flow rate of the sulfuric acid-containing solution passing through the filter 66 gradually increases with reduction in viscosity of the sulfuric acid-containing solution during the preliminary temperature control operation. In a case where the electrolytic circulation valve 64 is opened, the sulfuric acid-containing solution is circulated also through the electrolytic circulation path when the sulfuric acid-containing solution is allowed to pass through the filter 66. Thus, in the preliminary temperature control operation, heat is transferred from the sulfuric acid-containing solution to the electrolytic circulation pipe 61 to increase the temperature of the electrolytic circulation pipe 61 in advance. Initial reduction in temperature of the sulfuric acid-containing solution during the electrolytic sulfuric acid generation operation can thus be avoided. In a case where the external circulation valve 56 is opened, the sulfuric acid-containing solution is circulated also through the external circulation path. Thus, in the preliminary temperature control operation, heat is transferred from the sulfuric acid-containing solution to the external circulation pipe 55 to increase the temperature of the external circulation pipe 55 in advance. Initial reduction in temperature of the external circulation pipe 55 can thus be avoided. Assume herein that the controller 90 opens the electrolytic circulation valve 64 and the external circulation valve 56 in the preliminary temperature control operation.

In the preliminary temperature control operation, the first temperature sensor Sn11 measures the temperature of the sulfuric acid-containing solution at predetermined time intervals and outputs a result of measurement to the controller 90 each time the temperature is measured. In the example of FIG. 19, operation of the first temperature sensor Sn11 is schematically shown with hatching. The controller 90 determines whether the temperature measured by the first temperature sensor Sn11 is equal to or higher than a predetermined reference temperature. The controller 90 continues to perform the preliminary temperature control operation when the temperature measured by the first temperature sensor Sn11 is lower than the predetermined reference temperature.

On the other hand, the controller 90 ends the preliminary temperature control operation when the temperature measured by the first temperature sensor Sn11 is equal to or higher than the predetermined reference temperature. Specifically, the controller 90 closes the temperature control circulation valve 69. The sulfuric acid-containing solution is thus circulated not through the second temperature control circulation path but through the electrolytic circulation path and the external circulation path.

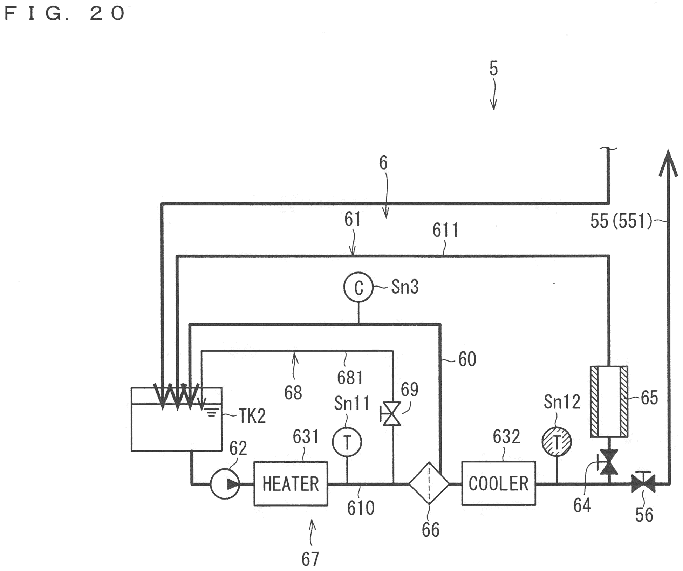

Next, the electrolytic sulfuric acid supply apparatus 5 performs the electrolytic sulfuric acid generation operation (step S12). FIG. 20 is a diagram schematically showing one example of a state of the electrolytic sulfuric acid supply apparatus 5 during the electrolytic sulfuric acid generation operation. As illustrated in FIG. 20, the controller 90 opens the electrolytic circulation valve 64. The controller 90 herein opens the electrolytic circulation valve 64 continuously from the preliminary temperature control operation. The controller 90 operates the electrolytic cell 65. The electrolytic cell 65 thus electrolyzes the sulfuric acid-containing solution. The electrolytic sulfuric acid concentration of the sulfuric acid-containing solution circulated through the electrolytic circulation path thus increases over time to be equal to or higher than the reference concentration at some point in time. That is to say, the electrolytic sulfuric acid solution is generated.

On the other hand, heat is generated in the electrolytic cell 65 in association with electrolysis. The temperature of the sulfuric acid-containing solution thus increases. Thus, in the electrolytic sulfuric acid generation operation, the controller 90 controls the cooler 632 based on the temperature measured by the second temperature sensor Sn12. The controller 90 controls the cooler 632 so that the temperature measured by the second temperature sensor Sn12 is within a predetermined temperature range. The temperature range is a temperature range suitable for electrolysis and is set in advance. As a specific example, a lower limit of the temperature range is set to a value equal to or higher than 40 °C, and an upper limit of the temperature range is set to a value equal to or lower than 60 °C.

As illustrated in FIG. 20, the controller 90 may open the external circulation valve 56 also in the electrolytic sulfuric acid generation operation. The sulfuric acid-containing solution (electrolytic sulfuric acid solution) is thus circulated through the electrolytic circulation path and the external circulation path.

In the examples of FIGs. 19 and 20, the sulfuric acid-containing solution flows also through the concentration separate pipe 60 in the preliminary temperature control operation and the electrolytic sulfuric acid generation operation. In the electrolytic sulfuric acid generation operation, the concentration sensor Sn3 may measure the electrolytic sulfuric acid concentration of the sulfuric acid-containing solution at predetermined time intervals and output an electrical signal indicating a result of measurement to the controller 90. The controller 90 may determine whether the electrolytic sulfuric acid concentration measured by the concentration sensor Sn3 is equal to or higher than a reference concentration and, when the electrolytic sulfuric acid concentration is equal to or higher than the reference concentration, may determine that the electrolytic sulfuric acid solution has been generated.

As described above, according to the second embodiment, in the preliminary temperature control operation, the controller 90 determines the temperature of the sulfuric acid-containing solution based on the temperature measured by the first temperature sensor Sn11. Specifically, the controller 90 closes the temperature control circulation valve 84 when the temperature measured by the first temperature sensor Sn11 is equal to or higher than the predetermined reference temperature during circulation of the sulfuric acid-containing solution through the temperature control circulation pipe 81. The first temperature sensor Sn11 is disposed between the heater 631 and the filter 66, so that the first temperature sensor Sn11 can measure the temperature of the sulfuric acid-containing solution immediately before the filter 66. The controller 90 can thus determine the temperature with higher determination accuracy.

Since the temperature control circulation valve 84 is closed in the electrolytic sulfuric acid generation operation, the sulfuric acid-containing solution is not circulated through the second temperature control circulation path. Circulation of the sulfuric acid-containing solution through an unnecessary path can thus be avoided. Power consumption of the electrolytic sulfuric acid supply apparatus 5 can thus be reduced.

In the electrolytic sulfuric acid generation operation, the controller 90 controls the cooler 632 based on the temperature measured by the second temperature sensor Sn12. The second temperature sensor Sn12 is disposed between the cooler 632 and the electrolytic cell 65, so that the temperature of the sulfuric acid-containing solution can be measured at a position close to the electrolytic cell 65. The controller 90 can thus control the temperature of the sulfuric acid-containing solution flowing into the electrolytic cell 65 with higher accuracy.

### <Temperature Control>

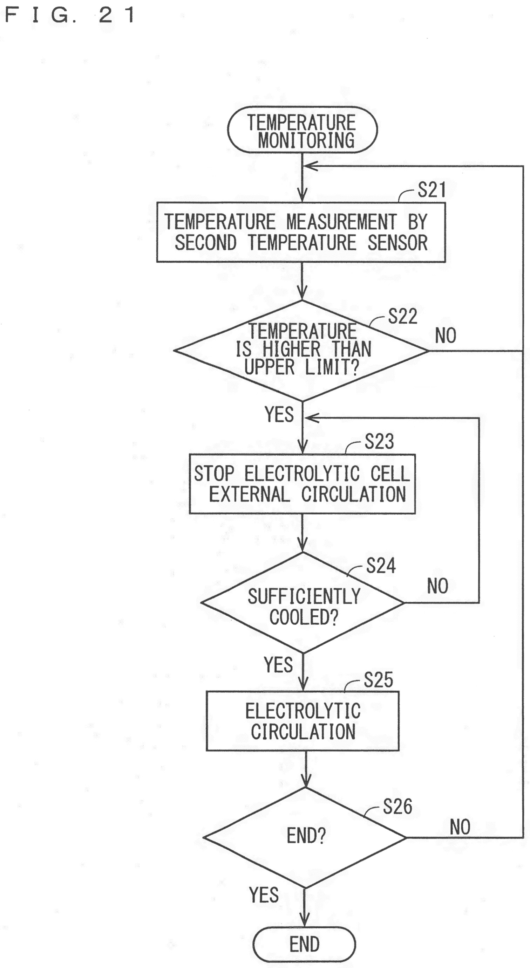

FIG. 21 is a flowchart showing one example of temperature control operation in the electrolytic sulfuric acid generation operation. The flowchart of FIG. 21 shows one example of operation when the cooler 632 cools the sulfuric acid-containing solution at a maximum cooling capacity, for example. First, the second temperature sensor Sn12 measures the temperature of the sulfuric acid-containing solution (step S21). The second temperature sensor Sn12 outputs the measured temperature to the controller 90.

Next, the controller 90 determines whether the temperature measured by the second temperature sensor Sn12 is higher than the upper limit of the temperature range (step S22). When the measured temperature is equal to or lower than the upper limit, the same step S21 is performed. On the other hand, when the measured temperature is higher than the upper limit, the controller 90 stops the electrolytic cell 65 to circulate the sulfuric acid-containing solution through the external circulation pipe 55 (step S23). Specifically, the controller 90 opens the external circulation valve 56. Since the external circulation valve 56 is herein opened in the electrolytic sulfuric acid generation operation, the controller 90 stops the electrolytic cell 65. Due to the stop of the electrolytic cell 65, a function of the electrolytic cell 65 as a heat source is stopped. The temperature of the electrolytic cell 65, however, is high immediately after the stop of the electrolytic cell 65. The sulfuric acid-containing solution is circulated through the external circulation pipe 55 while avoiding the electrolytic cell 65 having a high temperature, so that the temperature of the sulfuric acid-containing solution can more promptly be reduced. The sulfuric acid-containing solution passes through the cooler 632 also in the external circulation path including the generation tank Tk2 and the external circulation pipe 55. That is to say, the sulfuric acid-containing solution is circulated through the external circulation pipe 55 via the cooler 632. The temperature of the sulfuric acid-containing solution can thus more promptly be reduced. The controller 90 may close the electrolytic circulation valve 64. Supply of the sulfuric acid-containing solution to the electrolytic cell 65 can thus be stopped.

Next, the second temperature sensor Sn12 measures the temperature of the sulfuric acid-containing solution again (step S23). The second temperature sensor Sn12 outputs the measured temperature to the controller 90.

Next, the controller 90 determines whether the sulfuric acid-containing solution has sufficiently been cooled based on the measured temperature (step S24). The controller 90 may determine that the sulfuric acid-containing solution has sufficiently been cooled when the measured temperature is lower than the reference value that is lower than the upper limit, for example. When the measured temperature is equal to or higher than the reference value, step S23 is performed again. On the other hand, when the measured temperature is lower than the reference value, the controller 90 operates the electrolytic cell 65 again (step S25).

Next, the controller 90 determines whether the electrolytic sulfuric acid generation operation ends (step S26). When the controller 90 determines that the electrolytic sulfuric acid generation operation does not end, step S21 is performed again. When determining that the electrolytic sulfuric acid generation operation ends, the controller 90 ends operation of the electrolytic sulfuric acid supply apparatus 5.

As described above, when the temperature of the sulfuric acid-containing solution is higher than the upper limit, the temperature of the sulfuric acid-containing solution can more promptly be reduced by circulation through the external circulation pipe 55 without passing through the electrolytic cell 65 (heat source). The electrolytic cell 65 is stopped, so that the temperature of the sulfuric acid-containing solution can promptly be reduced.

### <Heater Control>

In the electrolytic sulfuric acid generation operation, the controller 90 may control the heater 631 based on the first temperature sensor Sn11. The controller 90 can thus control the temperature of the sulfuric acid-containing solution flowing into the cooler 632 with high accuracy. Specifically, the controller 90 may control the heater 631 so that the temperature measured by the first temperature sensor Sn11 falls within a predetermined second temperature range during circulation of the sulfuric acid-containing solution through the electrolytic circulation path. The second temperature range is a temperature range of the sulfuric acid-containing solution flowing into the cooler 632. The second temperature range is set in advance to a temperature range in which the cooler 632 can reduce the temperature of the sulfuric acid-containing solution to a temperature within a first temperature range. That is to say, the heater 631 may control the temperature of the sulfuric acid-containing solution flowing into the cooler 632 so that the temperature of the sulfuric acid-containing solution falls within the first temperature range by a cooling capacity of the cooler 632.

### <Concentration Sensor>

The electrolytic cell 65 electrolyzes water in the sulfuric acid-containing solution. A hydrogen gas and an oxygen gas are thus generated. Bubbles can flow in a downstream pipe portion of the electrolytic circulation pipe 61 between a downstream end of the electrolytic cell 65 and the ceiling of the generation tank Tk2. These bubbles are separated into a gas and a liquid in the generation tank Tk2. Few bubbles flow into an upstream pipe portion of the electrolytic circulation pipe 61 between the bottom of the generation tank Tk2 and an upstream end of the electrolytic cell 65.

In the example of FIG. 17, the concentration sensor Sn3 is disposed in the concentration separate pipe 60. The concentration separate pipe 60 diverges from the upstream pipe portion, so that few bubbles flow into the concentration separate pipe 60. The concentration separate pipe 60 diverges from a secondary side of the filter 66. The sulfuric acid-containing solution containing fewer impurities thus flows through the concentration separate pipe 60. The concentration sensor Sn3 can thus measure the electrolytic sulfuric acid concentration with higher accuracy.

### <Position of Upstream End of External Circulation Pipe>

With reference to FIG. 17, a pipe portion of the external circulation pipe 55 connecting the substrate processing apparatus 1 and the electrolytic sulfuric acid supply apparatus 5 on an upstream side is hereinafter referred to as an apparatus supply pipe 551. The sulfuric acid-containing solution flows through the apparatus supply pipe 551 toward the substrate processing apparatus 1.

In the example of FIG. 17, the apparatus supply pipe 551 diverges from the electrolytic circulation pipe 61 at a position between the filter 66 and the electrolytic cell 65. The electrolytic sulfuric acid solution having passed through the filter 66 is thus supplied to the substrate processing apparatus 1 through the apparatus supply pipe 551 without passing through the electrolytic cell 65. Since a clean electrolytic sulfuric acid solution after passing through the filter 66 does not pass through the electrolytic cell 65, the electrolytic sulfuric acid supply apparatus 5 can supply the electrolytic sulfuric acid solution to the substrate processing apparatus 1 while maintaining a high cleanness of the electrolytic sulfuric acid solution.

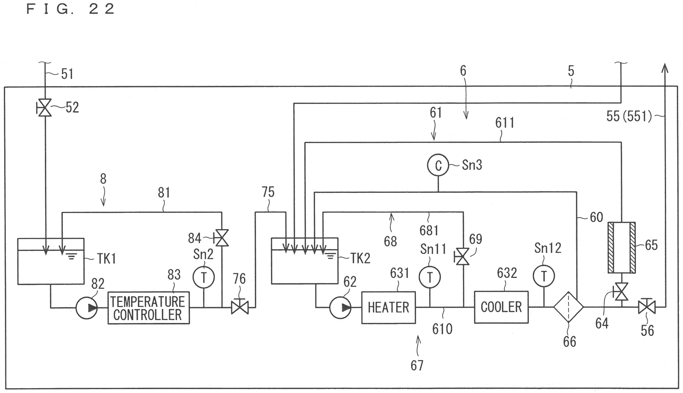

FIG. 22 is a diagram schematically showing a second example of the configuration of the electrolytic sulfuric acid supply apparatus 5 according to the second embodiment. The second example differs from the first example in a positional relationship between the cooler 632 and the filter 66. In the second example, the cooler 632 is disposed to be closer to the upstream end of the electrolytic separate pipe 611 than the filter 66 is. In the example of FIG. 22, the second temperature sensor Sn12 is disposed between the cooler 632 and the filter 66. The second temperature sensor Sn12, however, may be disposed between the filter 66 and the electrolytic cell 65.

In the example of FIG. 22, the apparatus supply pipe 551 diverges from a portion between the filter 66 and the electrolytic cell 65. That is to say, an upstream end of the apparatus supply pipe 551 is connected to the electrolytic circulation pipe 61 at a position between the filter 66 and the electrolytic cell 65. According to this structure, a clean electrolytic sulfuric acid solution having passed through the filter 66 is supplied to the substrate processing apparatus 1 through the apparatus supply pipe 551 without passing through the cooler 632 and the electrolytic cell 65. The electrolytic sulfuric acid supply apparatus 5 can thus supply the electrolytic sulfuric acid solution to the substrate processing apparatus 1 while maintaining a higher cleanness.

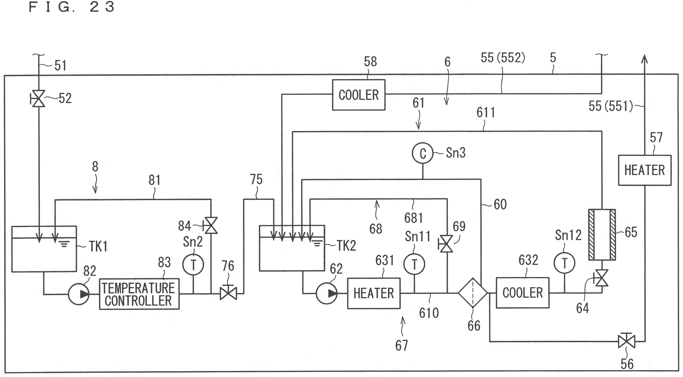

FIG. 23 is a diagram schematically showing a third example of the configuration of the electrolytic sulfuric acid supply apparatus 5 according to the second embodiment. The third example differs from the first example in a position of the upstream end of the apparatus supply pipe 551. In the third example, the upstream end of the apparatus supply pipe 551 is connected to the electrolytic circulation pipe 61 at a position between the filter 66 and the cooler 632. In other words, the apparatus supply pipe 551 diverges from the electrolytic circulation pipe 61 at the position between the filter 66 and the cooler 632.

Furthermore, in the example of FIG. 23, the heater 57 is disposed in the apparatus supply pipe 551. The heater 57 is controlled by the controller 90 and heats the electrolytic sulfuric acid solution flowing through the apparatus supply pipe 551. The heater 57 heats the electrolytic sulfuric acid solution so that the temperature of the electrolytic sulfuric acid solution falls within a processing temperature range suitable for decomposable removal of organic matter on the substrate W.

In the example of FIG. 23, a cooler 58 is disposed in an external separate pipe 552 of the external circulation pipe 55 returning from the substrate processing apparatus 1. The cooler 58 is similar to the cooler 632, for example. The cooler 58 is controlled by the controller 90 and cools the electrolytic sulfuric acid solution.

According to the third example, the cooler 632 is not located on a path from the generation tank Tk2 to the apparatus supply pipe 551. The electrolytic sulfuric acid solution from the generation tank Tk2 is thus supplied to the apparatus supply pipe 551 without passing through the cooler 632. The electrolytic sulfuric acid solution flowing through the apparatus supply pipe 551 is heated by the heater 57. That is to say, the electrolytic sulfuric acid solution having passed through the filter 66 is heated by the heater 57 without being cooled by the cooler 632. Power consumption of the heater 57 to increase the temperature of the electrolytic sulfuric acid solution to a temperature within the processing temperature range can thus be reduced.

While the electrolytic sulfuric acid supply apparatus 5 and the water replacement method for the electrolytic sulfuric acid supply apparatus 5 have been described in detail above, the foregoing description is in all aspects illustrative and not restrictive. Various modifications described above can be combined for application unless any contradiction occurs. It is understood that numerous unillustrated modifications can be devised without departing from the scope of the present disclosure.

The present disclosure includes aspects described below.

A first aspect is an electrolytic sulfuric acid supply apparatus including: a collection tank connected to a substrate processing apparatus via a collection pipe and storing a sulfuric acid-containing solution including an electrolytic sulfuric acid solution, the substrate processing apparatus supplying the electrolytic sulfuric acid solution to a substrate to remove organic matter on the substrate; a generation tank; a bidirectional pipe connecting the collection tank and the generation tank; a bidirectional first liquid feeder disposed in the bidirectional pipe; an electrolytic circulator including an electrolytic circulation pipe connected to the generation tank and an electrolytic cell disposed in the electrolytic circulation pipe, the electrolytic circulator causing the electrolytic cell to electrolyze the sulfuric acid-containing solution to generate the electrolytic sulfuric acid solution while circulating the sulfuric acid-containing solution through the generation tank and the electrolytic circulation pipe; a supply pipe connected to the generation tank and allowing the electrolytic sulfuric acid solution to flow therethrough toward the substrate processing apparatus; a water supply including a water supply pipe and a water supply valve disposed in the water supply pipe, the water supply pipe supplying water to the collection tank; and a drain including a first drainage pipe connected to the collection tank, a first drainage valve disposed in the first drainage pipe, a second drainage pipe connected to the generation tank, and a second drainage valve disposed in the second drainage pipe.

A second aspect is the electrolytic sulfuric acid supply apparatus according to the first aspect, wherein the first liquid feeder includes: a bellows pump disposed in the bidirectional pipe and not including a check valve; a collection-side valve disposed in the bidirectional pipe to be closer to the collection tank than the bellows pump is; and a generation-side valve disposed in the bidirectional pipe to be closer to the generation tank than the bellows pump is.

A third aspect is the electrolytic sulfuric acid supply apparatus according to the first or the second aspect, further including: a sulfuric acid supply pipe connecting the collection tank and the generation tank; and a unidirectional second liquid feeder disposed in the sulfuric acid supply pipe and allowing the sulfuric acid-containing solution to flow therethrough from the collection tank to the generation tank.

A fourth aspect is a water replacement method for an electrolytic sulfuric acid supply apparatus, the water replacement method including: while supplying water to a collection tank storing a sulfuric acid-containing solution including an electrolytic sulfuric acid solution drained from a substrate processing apparatus, draining the sulfuric acid-containing solution in the collection tank, the substrate processing apparatus supplying the electrolytic sulfuric acid solution to a substrate to remove organic matter on the substrate; after draining the sulfuric acid-containing solution in the collection tank, operating a bidirectional first liquid feeder disposed in a bidirectional pipe connecting the collection tank and a generation tank to drain the sulfuric acid-containing solution in the bidirectional pipe while supplying the water from the collection tank to the generation tank through the bidirectional pipe; and after draining the sulfuric acid-containing solution in the bidirectional pipe, supplying water to the generation tank and circulating the water through an electrolytic circulation pipe which is connected to the generation tank and in which an electrolytic cell is disposed to drain the sulfuric acid-containing solution in the generation tank.

A fifth aspect is the water replacement method for the electrolytic sulfuric acid supply apparatus according to the fourth aspect, wherein in draining the sulfuric acid-containing solution in the collection tank, the water is circulated through a temperature control circulation pipe which is connected to the collection tank and in which a temperature controller is disposed to drain the sulfuric acid-containing solution in the collection tank, and after draining the sulfuric acid-containing solution in the collection tank and before draining the sulfuric acid-containing solution in the generation tank and the electrolytic circulation pipe, a unidirectional second liquid feeder is operated to supply water from the collection tank to the generation tank through a sulfuric acid supply pipe and drain the sulfuric acid-containing solution in the sulfuric acid supply pipe.

A sixth aspect is the water replacement method for the electrolytic sulfuric acid supply apparatus according to the fifth aspect, wherein after supplying water from the collection tank to the generation tank through the sulfuric acid supply pipe diverging from the temperature control circulation pipe, the sulfuric acid-containing solution in the bidirectional pipe is drained.

A seventh aspect is the water replacement method for the electrolytic sulfuric acid supply apparatus according to the fifth or the sixth aspect, the water replacement method further including: collecting the sulfuric acid-containing solution containing residual organic matter from the substrate processing apparatus in the collection tank; after collecting the sulfuric acid-containing solution in the collection tank, operating the bidirectional first liquid feeder to supply the electrolytic sulfuric acid solution from the generation tank to the collection tank through the bidirectional pipe and decomposing the residual organic matter in the collection tank with the electrolytic sulfuric acid solution; and after decomposing the residual organic matter in the collection tank, operating the second liquid feeder to supply the sulfuric acid-containing solution in the collection tank to the generation tank.

According to the first aspect, the sulfuric acid-containing solution drained from the substrate processing apparatus can contain the residual organic matter. That is to say, the residual organic matter can be contained in the collection tank. In the normal operation, the electrolytic sulfuric acid solution is supplied from the generation tank to the collection tank through the bidirectional pipe, so that the residual organic matter in the collection tank can be decomposed with the electrolytic sulfuric acid solution. The sulfuric acid-containing solution containing a small amount of the residual organic matter can be supplied from the collection tank to the generation tank.

On the other hand, during maintenance, after the sulfuric acid-containing solution in the collection tank is replaced with water, water can be supplied to the generation tank through the bidirectional pipe. The sulfuric acid-containing solution in the generation tank and the electrolytic circulation pipe can then be replaced with water. Replacement with water can be performed sequentially from a member on an upstream side (the collection tank) to a member on a downstream side (the generation tank and the electrolytic circulation pipe). The water replacement operation can thus be performed at a high throughput.

According to the second aspect, the bellows pump having a small slide part is used, so that generation of particles due to the slide can be reduced to reduce the likelihood of entry of the particles into the electrolytic sulfuric acid solution.

According to the third aspect, in the normal operation, the sulfuric acid-containing solution can be supplied from the collection tank to the generation tank through the supply pipe, and electrolytic sulfuric acid can be supplied from the generation tank to the collection tank through the bidirectional pipe. In the normal operation, a liquid unidirectionally flows through each of the supply pipe and the bidirectional pipe, so that dirt is less likely to be accumulated in each pipe.

On the other hand, during the water replacement operation, such as maintenance, after the sulfuric acid-containing solution in the collection tank is replaced with water, water can be supplied to the generation tank through the supply pipe and the bidirectional pipe. Replacement with water can thus be performed sequentially from a member on an upstream side.

According to the fourth aspect, after the sulfuric acid-containing solution in the collection tank is drained, water is supplied to the generation tank through the bidirectional pipe, and then the sulfuric acid-containing solution in the generation tank and the electrolytic circulation pipe is drained. Sulfuric acid can thus be drained sequentially from the member on the upstream side (the collection tank) to the member on the downstream side (the generation tank and the electrolytic circulation pipe). Sulfuric acid can thus be drained at a higher throughput.

According to the fifth aspect, after sulfuric acid in the sulfuric acid supply pipe on an upstream side of the generation tank is drained, sulfuric acid in the generation tank is drained. Sulfuric acid can thus be drained sequentially from the member on the upstream side and can be drained at a higher throughput.

According to the sixth aspect, promptly after drainage of sulfuric acid in the temperature control circulation pipe, sulfuric acid in the sulfuric acid supply pipe connected to the temperature control circulation pipe is drained. A likelihood of a flow of sulfuric acid in the sulfuric acid supply pipe into the temperature control circulation pipe can thus be reduced, and, by extension, remaining of sulfuric acid in the temperature control circulation pipe can more surely be avoided.

According to the seventh aspect, supply to the generation tank can be performed after decomposition of the residual organic matter in the collection tank.

While the disclosure has been shown and described in detail, the foregoing description is in all aspects illustrative and not restrictive. It is therefore understood that numerous modifications and variations can be devised.

## Claims

1. An electrolytic sulfuric acid supply apparatus comprising:
a collection tank (Tkl) connected to a substrate processing apparatus (1) via a collection pipe (51) and storing a sulfuric acid-containing solution including an electrolytic sulfuric acid solution, the substrate processing apparatus (1) supplying the electrolytic sulfuric acid solution to a substrate (W) to remove organic matter on the substrate (W);
a generation tank (Tk2);
a bidirectional pipe (71) connecting the collection tank (Tk1) and the generation tank (Tk2);
a bidirectional first liquid feeder (72) disposed in the bidirectional pipe (71);
an electrolytic circulator (6) including an electrolytic circulation pipe (61) connected to the generation tank (Tk2) and an electrolytic cell (65) disposed in the electrolytic circulation pipe (61), the electrolytic circulator (6) causing the electrolytic cell (65) to electrolyze the sulfuric acid-containing solution to generate the electrolytic sulfuric acid solution while circulating the sulfuric acid-containing solution through the generation tank (Tk2) and the electrolytic circulation pipe (61);
a supply pipe connected to the generation tank (Tk2) and allowing the electrolytic sulfuric acid solution to flow therethrough toward the substrate processing apparatus (1);
a water supply (3) including a water supply pipe (31) and a water supply valve (33) disposed in the water supply pipe (31), the water supply pipe (31) supplying water to the collection tank (Tk1); and
a drain (4) including a first drainage pipe (41) connected to the collection tank (Tk1), a first drainage valve (42) disposed in the first drainage pipe (41), a second drainage pipe (43) connected to the generation tank (Tk2), and a second drainage valve (44) disposed in the second drainage pipe (43).

2. The electrolytic sulfuric acid supply apparatus according to claim 1, wherein the first liquid feeder (72) includes:
a bellows pump (721) disposed in the bidirectional pipe (71) and not including a check valve;
a collection-side valve (726) disposed in the bidirectional pipe (71) to be closer to the collection tank (Tk1) than the bellows pump (721) is; and
a generation-side valve (727) disposed in the bidirectional pipe (71) to be closer to the generation tank (Tk2) than the bellows pump (721) is.

3. The electrolytic sulfuric acid supply apparatus according to claim 1 or 2, further comprising:
a sulfuric acid supply pipe (75) connecting the collection tank (Tkl) and the generation tank (Tk2); and
a unidirectional second liquid feeder (82) disposed in the sulfuric acid supply pipe (75) and allowing the sulfuric acid-containing solution to flow therethrough from the collection tank (Tk1) to the generation tank (Tk2).

4. A water replacement method for an electrolytic sulfuric acid supply apparatus, the water replacement method comprising:
while supplying water to a collection tank (Tk1) storing a sulfuric acid-containing solution including an electrolytic sulfuric acid solution drained from a substrate processing apparatus (1), draining the sulfuric acid-containing solution in the collection tank (Tk1), the substrate processing apparatus (1) supplying the electrolytic sulfuric acid solution to a substrate (W) to remove organic matter on the substrate (W);
after draining the sulfuric acid-containing solution in the collection tank (Tk1), operating a bidirectional first liquid feeder (72) disposed in a bidirectional pipe (71) connecting the collection tank (Tk1) and a generation tank (Tk2) to drain the sulfuric acid-containing solution in the bidirectional pipe (71) while supplying the water from the collection tank (Tk1) to the generation tank (Tk2) through the bidirectional pipe (71); and
after draining the sulfuric acid-containing solution in the bidirectional pipe (71), supplying water to the generation tank (Tk2) and circulating the water through an electrolytic circulation pipe (61) which is connected to the generation tank (Tk2) and in which an electrolytic cell (65) is disposed to drain the sulfuric acid-containing solution in the generation tank (Tk2).

5. The water replacement method for the electrolytic sulfuric acid supply apparatus according to claim 4, wherein
in draining the sulfuric acid-containing solution in the collection tank (Tk1), the water is circulated through a temperature control circulation pipe (81) which is connected to the collection tank (Tk1) and in which a temperature controller (83) is disposed to drain the sulfuric acid-containing solution in the collection tank (Tk1), and
after draining the sulfuric acid-containing solution in the collection tank (Tk1) and before draining the sulfuric acid-containing solution in the generation tank (Tk2) and the electrolytic circulation pipe (61), a unidirectional second liquid feeder (82) is operated to supply water from the collection tank (Tk1) to the generation tank (Tk2) through a sulfuric acid supply pipe (75) and drain the sulfuric acid-containing solution in the sulfuric acid supply pipe (75).

6. The water replacement method for the electrolytic sulfuric acid supply apparatus according to claim 5, wherein
after supplying water from the collection tank (Tk1) to the generation tank (Tk2) through the sulfuric acid supply pipe (75) diverging from the temperature control circulation pipe (81), the sulfuric acid-containing solution in the bidirectional pipe (71) is drained.

7. The water replacement method for the electrolytic sulfuric acid supply apparatus according to claim 5 or 6, the water replacement method further comprising:
collecting the sulfuric acid-containing solution containing residual organic matter from the substrate processing apparatus (1) in the collection tank (Tk1);
after collecting the sulfuric acid-containing solution in the collection tank (Tk1), operating the bidirectional first liquid feeder (72) to supply the electrolytic sulfuric acid solution from the generation tank (Tk2) to the collection tank (Tk1) through the bidirectional pipe (71) and decomposing the residual organic matter in the collection tank (Tk1) with the electrolytic sulfuric acid solution; and
after decomposing the residual organic matter in the collection tank (Tk1), operating the second liquid feeder (82) to supply the sulfuric acid-containing solution in the collection tank (Tk1) to the generation tank (Tk2).
